(19) **Europäisches Patentamt**
**European Patent Office**
**Office européen des brevets**

(11) **EP 1 998 321 B1**

(12) **EUROPEAN PATENT SPECIFICATION**

(45) Date of publication and mention
of the grant of the patent:
**27.03.2013 Bulletin 2013/13**

(51) Int Cl.:
***G10L 19/02*** *(2013.01)*

(21) Application number: **08164671.3**

(22) Date of filing: **26.05.2005**

(54) **Method and apparatus for encoding/decoding a digital signal**

Verfahren und Vorrichtung zur Kodierung/Dekodierung eines digitalen Signals

Procédé et dispositif pour le codage/décodage d'un signal numérique

(84) Designated Contracting States:
**GB NL**

(30) Priority: **28.05.2004 KR 20040038212**

(43) Date of publication of application:
**03.12.2008 Bulletin 2008/49**

(62) Document number(s) of the earlier application(s) in
accordance with Art. 76 EPC:
**05253245.4 / 1 600 946**

(73) Proprietor: **Samsung Electronics Co., Ltd.**
**Suwon-si, Gyeonggi-do, 443-742 (KR)**

(72) Inventors:
 • **Kim, Dohyung**
 **Gyeonggi-do (KR)**
 • **Kim, Junghoe**
 **Seoul (KR)**
 • **Lee, Shihwa**
 **Seoul (KR)**

 • **Kim, Sangwook**
 **Seoul (KR)**
 • **Seo, Yangseock**
 **Gyeonggi-do (KR)**

(74) Representative: **Greene, Simon Kenneth**
**Elkington and Fife LLP**
**Prospect House**
**8 Pembroke Road**
**Sevenoaks**
**Kent TN13 1XR (GB)**

(56) References cited:
**US-A- 5 864 802**

 • **HIROTO SAITO ET AL: "Subadaptive Piecewise**
**Linear Quantization for Speech Signal (64 kbit/s)**
**Compression" IEEE TRANSACTIONS ON**
**SPEECH AND AUDIO PROCESSING, IEEE**
**SERVICE CENTER, NEW YORK, NY, US, vol. 4,**
**no. 5, 1 September 1996 (1996-09-01),**
**XP011054210 ISSN: 1063-6676**

**Description**

Embodiments of the present invention relate to encoding and decoding of a digital signal, and more particularly, to a method and apparatus for encoding/decoding a digital signal, in which a digital signal is encoded into a bit stream including information about a length of a frame by using linear quantization by sections, and the bit stream is decoded into the original digital signal.

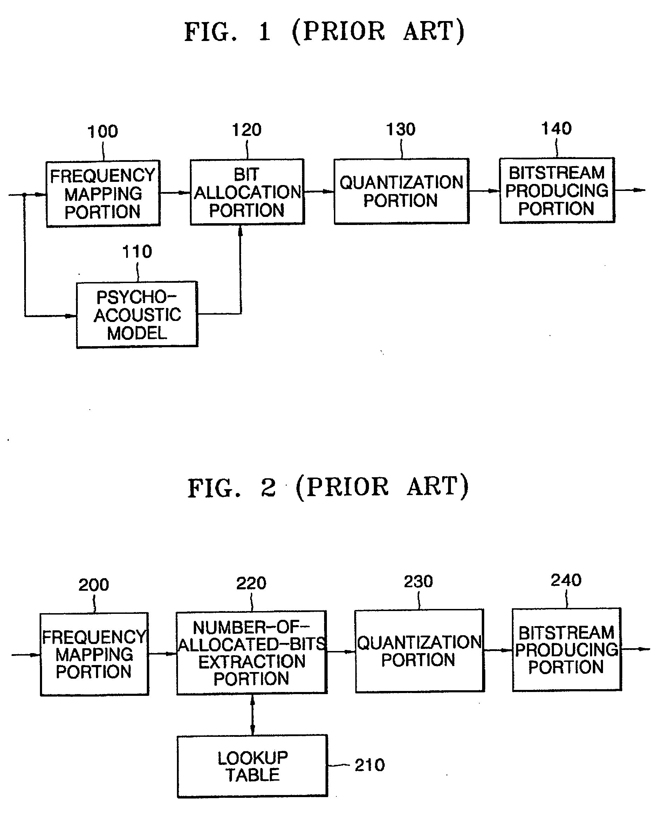

FIG. 1 is a block diagram of a general digital signal encoding apparatus using an acoustic psychology model in the MPEG-1. The general digital signal encoding apparatus is comprised of a frequency mapping portion 100, an acoustic psychology (psycho-acoustic) model 110, a bit allocation portion 120, a quantization portion 130, and a bitstream producing portion 140.

The frequency mapping portion 100 transforms a time-domain input signal into a predetermined number of frequency bands using a band analysis filter. The acoustic psychology model 110 is a portion of the encoding apparatus that performs the most complicate calculation. That is, the acoustic psychology model 110 calculates a signal-to-mask ratio (SMR), which is a basis of bit allocation for each frequency band. The SMR is calculated by the following operations. First, a time-domain audio signal is transformed into a frequency-domain audio signal using fast Fourier transform (FFT), and a sound pressure level and an absolute threshold of each frequency band are calculated. Thereafter, voice and voiceless sound components of the audio signal and a masker of the audio signal are determined, and a masking threshold of each frequency band and an overall masking threshold are calculated. Finally, a minimal masking threshold of each frequency band is calculated, thereby calculating the SMR of each frequency band.

The bit allocation portion 120 calculates the number of bits to be allocated for each frequency band by repeating the following operations based on the SMR received from the acoustic psychology model 110. First, an initial allocated bit is set as 0, and a mask-to-noise ratio (MNR) for each frequency band is obtained. Here, the MNR is obtained by subtracting the SMR from a signal-to-noise ratio (SNR). Thereafter, a frequency band having the minimal MNR among MNRs for the frequency bands is searched for, and the number of bits allocated for the found frequency band increases 1. If the number of bits allocated for the entire input signal does not exceed a required number of allocated bits, frequency bands other than the found frequency band undergo the above-described operations.

The quantization portion 130 quantizes the input signal using a scale vector and allocated bits. The bitstream producing portion 140 produces a bit stream using the quantized input signal.

As described above, a conventional digital signal encoding method using an acoustic psychology model obtains an SMR through a complicated process. Thus, a calculation performed in the conventional digital signal encoding method becomes complicated, leading to an increase in the time required to execute the digital signal encoding method. Since an MNR is calculated using the SMR obtained through the complicate process, and a bit allocation loop is repeated based on the MNR, time delay also occurs during the repetition of the bit allocation loop.

FIG. 2 is a block diagram of a conventional digital signal encoding apparatus using a single lookup table. The encoding apparatus is comprised of a frequency mapping portion 200, a lookup table 210, a number-of-allocated-bits extraction portion 220, a quantization portion 230, and a bitstream producing portion 240.

The frequency mapping portion 200 transforms a time-domain input signal into a predetermined number of frequency bands using a band analysis filter. The lookup table 210 stores numbers of bits allocated to encode the frequency bands, in addresses corresponding to characteristics of the frequency bands.

The number-of-allocated-bits extraction portion 220 calculates an address value for each of the frequency bands of the input signal and extracts the numbers of allocated bits stored in the addresses for the frequency bands from the lookup table 210. The quantization portion 230 quantizes the input signal using the numbers of bits allocated for the frequency bands. The bitstream producing portion 240 produces a bitstream using the quantized input signal.

In a conventional method of encoding a digital signal using a single lookup table, to obtain a number of bits allocated for a unit in which the digital signal is quantized (hereafter, referred to as a quantization unit) as described above, the numbers of bits allocated per frequency band are extracted from the lookup table and used in encoding the digital signal. Hence, the complicated calculation and the time delay due to the use of an acoustic psychology model can be prevented. However, since various input signals having different characteristics must be encoded using the single lookup table, there exists a limit in adaptively encoding the input signals according to their characteristics.

In the MPEG-1/2 audio encoding technology, sub-band samples obtained by sub-band filtering are linearly quantized using information about bit allocation presented by psychoacoustics and undergo a bit packing process, thereby completing audio encoding. A linear quantizer, which performs the linear quantization, provides optimal performance when data has a uniform distribution. However, a data distribution is actually approximate to a Guassian or Laplacian distribution. Hence, the quantizer is preferably designed to fit each distribution, and can show an optimal result in respect of a mean squared error (MSE). A general audio encoder, such as, an MPEG-2/4 Advanced Audio Coding (AAC) encoder, uses a $x^{4/3}$ nonlinear quantizer, which is designed in consideration of a sample distribution of a modified discrete cosine transform (MDCT) and the psycho-acoustic perspective. However, the encoder is highly complex due to the characteristics of a nonlinear quantizer. Therefore, the nonlinear quantizer cannot be used as an audio encoder that requires low complexity.

When audio encoding proposed by MPEG-1 and MPEG-2 is performed using a fixed bitrate, sync information is located at a beginning portion of each frame. When audio encoding proposed by MPEG-4 is not performed at a fixed bitrate, information about a frame length is located at a beginning portion of each frame.

When an impact is applied to an audio reproducing apparatus, only effective data, which is not affected by the impact, except for an impacted portion of a buffer in the audio reproducing apparatus should be reproduced. When an encoding rate used is a fixed bit rate, a length of each frame, that is, a size of an area of the buffer occupied by each frame, is consistent. Accordingly, an area of the buffer occupied by a frame previous to a damaged frame can be easily searched for. On the other hand, when the encoding rate used is a variable bit rate, a length of each frame, that is, a size of an area of the buffer occuped by each frame, is inconsistent. Accordingly, it is impossible to search for an area of the buffer occupied by a frame previous to a damaged frame by only using frame length information recorded at a beginning portion of each frame.

Saito et al, "Subadaptive Piecewise Linear Quantization for Speech Signal Compression", IEEE transactions on speech and audio processing, volume 4, number 5, September 1996, describes piecewise linear quantization of speech signal samples.

According to aspects of the present invention, there is provided an encoding method according to claim 1, an encoding apparatus according to claim 2, a decoding method according to claim 4, a decoding apparatus according to claim 7, a computer program according to claim 10. and a computer-readable medium according to claim 11.

Additional aspects and/or advantages of the invention will be set forth in part in the description which follows and, in part, will be apparent from the description, or may be learned by practice of the invention.

These and/or other aspects and advantages of the invention will become apparent and more readily appreciated from the following description of the embodiments, taken in conjunction with the accompanying drawings of which:

FIG. 1 is a block diagram of a conventional digital signal encoding apparatus using an acoustic psychology model in the MPEG-1;

FIG. 2 is a block diagram of a conventional digital signal encoding apparatus using a single lookup table;

FIG. 3 is a block diagram of a digital signal encoding apparatus using a plurality of lookup tables and linear quantization by sections;

FIG. 4 is a block diagram of a detailed structure of a linear quantization portion of FIG 3;

FIG. 5 is a flowchart illustrating a digital signal encoding method using a plurality of lookup tables and linear quantization by sections;

FIG. 6 is a flowchart illustrating an embodiment of an operation of selecting one of the lookup tables illustrated in FIG. 5;

FIGS. 7A and 7B are graphs illustrating occupancy rates for frequency bands of an input signal;

FIG. 8 is a flowchart illustrating an embodiment of an operation of allocating a number of bits allocated to each frequency band illustrated in FIG. 5;

FIG. 9 is a flowchart illustrating operation 560 shown in FIG. 5;

FIG. 10 illustrates a distribution of sub-band samples obtained by normalizing sample data;

FIG. 11 is a graph illustrating two sections into which the range of normalized values is divided;

FIG. 12 is a graph illustrating a quantizer designed according to a Lloyd-Max algorithm based on the distribution of FIG. 10;

FIG. 13 is a block diagram of a digital signal encoding apparatus having improvements in a bit allocation portion and a bit packing portion, according to an embodiment of the present invention;

FIG. 14 illustrates an example of a frame structure of a bitstream;

FIG. 15 illustrates another example of a frame structure of a bitstream;

FIG. 16 is a flowchart illustrating a digital signal encoding method in which a bit stream including frame length information is produced using a plurality of lookup tables,

FIG. 17 is a block diagram of a digital signal encoding apparatus having improvements in a linear quantization portion and a bit packing portion;

FIG. 18 is a flowchart illustrating a digital signal encoding method in which a bit stream including frame length information is produced using linear quantization by sections;

FIG. 19 is a block diagram of a digital signal encoding apparatus having improvements in a lookup table, a bit allocation portion, and a bit packing portion;

FIG. 20 is a flowchart illustrating a digital signal encoding method in which a bit stream including frame length information is produced using a plurality of lookup tables and linear quantization by sections;

FIG. 21 is a flowchart illustrating a method of producing a plurality of lookup tables;

FIG. 22 is a flowchart illustrating a method of producing a plurality of lookup tables;

FIG. 23 is a table illustrating a method of setting addresses used in a lookup table;

FIG. 24 is a table illustrating a method of producing a lookup table;

FIG. 25 is a block diagram of a digital signal decoding apparatus corresponding to a digital signal encoding apparatus in which linear quantization by sections is performed using a plurality of lookup tables;

FIG. 26 is a block diagram of a detailed structure of a linear dequantization portion of FIG. 25;

FIG. 27 is a flowchart illustrating a digital signal decoding method corresponding to a digital signal encoding method in which linear quantization by sections is performed using a plurality of lookup tables;

FIG. 28 is a flowchart illustrating an operation of dequantizing sample data;

FIG. 29 is a block diagram of a digital signal decoding apparatus corresponding to a digital signal encoding apparatus in which a bit stream including frame length information is produced using a plurality of lookup tables;

FIG. 30 is a block diagram of a bit stream analyzing portion of FIG. 29;

FIG. 31 is a flowchart illustrating a digital signal decoding method corresponding to a digital signal encoding method in which a bit stream including frame length information is produced using a plurality of lookup tables;

FIG. 32 is a block diagram of a digital signal decoding apparatus corresponding to a digital signal encoding apparatus in which a bit stream including frame length information is produced using a plurality of lookup tables and linear quantization by sections and to a digital signal encoding apparatus in which a bit stream including frame length information is produced using linear quantization by sections; and

FIG. 33 is a flowchart illustrating a digital signal decoding method corresponding to a digital signal encoding method in which a bit stream including frame length information is produced using a plurality of lookup tables and linear quantization by sections and to a digital signal encoding method in which a bit stream including frame length information is produced using linear quantization by sections.

Reference will now be made in detail to the embodiments of the present invention, examples of which are illustrated in the accompanying drawings, wherein like reference numerals refer to the like elements throughout. The embodiments are described below to explain the present invention by referring to the figures.

A digital signal encoding/decoding method and apparatus will now be described in detail with reference to the accompanying drawings,

A digital signal encoding apparatus is obtained by improving a bit allocation portion, a quantization portion, and a bit packing portion of a general digital signal encoding apparatus, which further includes a data transformation portion. To be more specific, the improved bit allocation portion calculates a number of bits allocated for a unit in which a digital input signal is quantized (hereinafter, referred as a quantization unit), using a plurality of lookup tables produced based on characteristics of an input signal. The improved quantization portion performs linear quantization by sections. The bit packing portion produces a bitstream including information about a length of a frame.

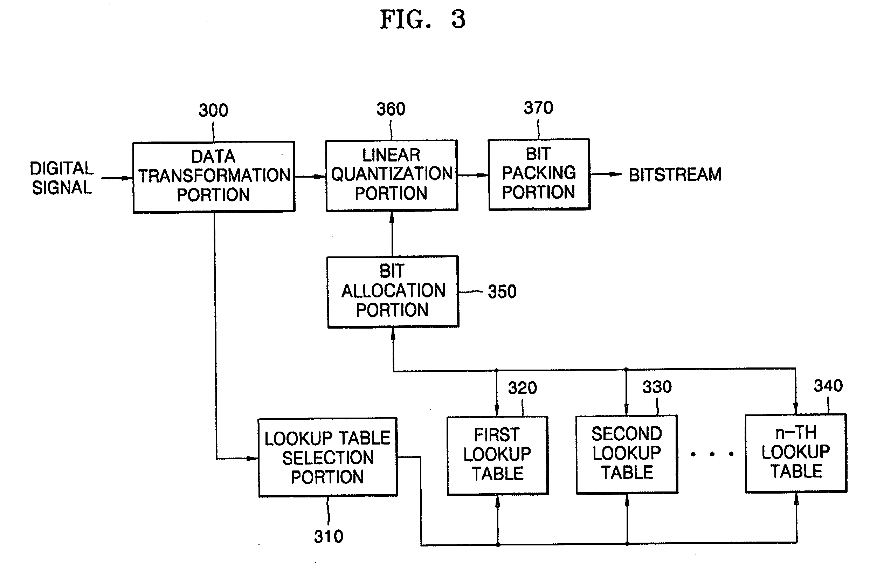

Accordingly, the description describes an encoding apparatus including the improved bit allocation portion and the improved linear quantization portion; an encoding apparatus including the improved bit allocation portion and the improved bit packing portion; an encoding apparatus including the improved linear quantization portion and the improved bit packing portion; and an encoding apparatus including the improved bit allocation portion, the improved linear quantization portion, and the improved bit packing portion. First, the digital signal encoding apparatus including the improved bit allocation portion and the improved linear quantization portion will be described with reference to FIG. 3. Referring to FIG. 3, the digital signal encoding apparatus includes a data transformation portion 300, a lookup table selection portion 310, first through n-th lookup tables 320, 330, and 340, a bit allocation portion 350, a linear quantization portion 360, and a bit packing portion 370.

The data transformation portion 300 transforms a digital input signal to remove redundant information among signals. The digital input signal may be a pulse-code modulation (PCM) sampled signal. The PCM sampled signal, which is a time-domain input signal, is transformed into a frequency-domain signal, which is divided by a predetermined number of frequency bands, using sub-band filters. The digital input signal is quantized in units of a frequency band. Hereinafter, the frequency bands will be used as an example of a quantization unit. The digital signal, for example, the PCM sampled signal, may be transformed through discrete cosine transform (DCT), modified DCT (MDCT), fast Fourier transform (FFT), or the like, instead of using the sub-band filters, so that redundant information can be removed from data.

The lookup tables 320, 330, and 340 are produced based on characteristics of the input signal. The lookup tables 320, 330, and 340 store the numbers of bits allocated to encode quantization units of the input signal, in a predetermined number of addresses. Since the input signal is transformed using the sub-band filters, the quantization unit of the input signal is a frequency band. The characteristics of the input signal may be the number of frequency bands among the frequency bands of the input signal, whose occupancy rates are no greater than or no less than a predetermined reference value. The occupancy rate of each frequency band may be a larger value between an occupancy rate of a squared scale factor of the frequency band and an occupancy rate of a mean power of the frequency band. The addresses used in each of the lookup tables are set to values indicating characteristics of the frequency bands of the input signal. For example, the addresses used in each of the lookup tables may be set to a variance of each frequency band, a scale factor of each frequency band, a squared scale factor of each frequency band, a mean value of sampled input signals within each frequency band, a mean power of the sampled input signals within each frequency band, a larger value between an occupancy rate of the scale factor of each frequency band and an occupancy rate of the mean value of the input signals within each frequency band, or a larger value between an occupancy rate of the squared scale factor of each frequency band and an occupancy rate of the mean power of the input signals within each frequency band.

The occupancy rate of the scale factor of each frequency band, $SR_{scf}$, the occupancy rate of the mean value of the input signals within each frequency band, $SR_{mean}$, the occupancy rate of the squared scale factor, $SR_{squared\_scf}$, and the occupancy rate of the mean power of the input signals within each frequency band, $SR_{mean\_power}$, can be calculated as in Equation 1:

$$SR_{squared\_scf}[ch][sb] = \frac{squared\_scf[ch][sb]}{\sum_{ch}\sum_{sb} squared\_scf[ch][sb]}$$

$$SR_{mean\_pwr}[ch][sb] = \frac{mean\_pwr[ch][sb]}{\sum_{ch}\sum_{sb} mean\_pwr[ch][sb]}$$

wherein scf denotes a scale factor, mean denotes a mean value, ch denotes a left or right channel which calculates an occupancy rate from an audio signal, and sb denotes a frequency band having the occupancy rate.

The lookup table selection portion 310 selects one among the lookup tables 320, 330, and 340 according to the characteristics of the input signal, which have been considered when producing the lookup tables 320, 330, and 340.

The bit allocation portion 350 calculates address values for quantization units of the input signal, e.g., address values for the frequency bands of the input signal obtained using the sub-band filters, extracts numbers of allocated bits for the frequency bands corresponding to the calculated address values from the selected lookup table, and allocates the extracted numbers of bits to the corresponding frequency bands. The addresses for the frequency bands are set upon production of the lookup tables 320, 330, and 340. Hence, the bit allocation portion 350 calculates values indicating the characteristics of the frequency bands of the input signal to serve as the address values of the frequency bands.

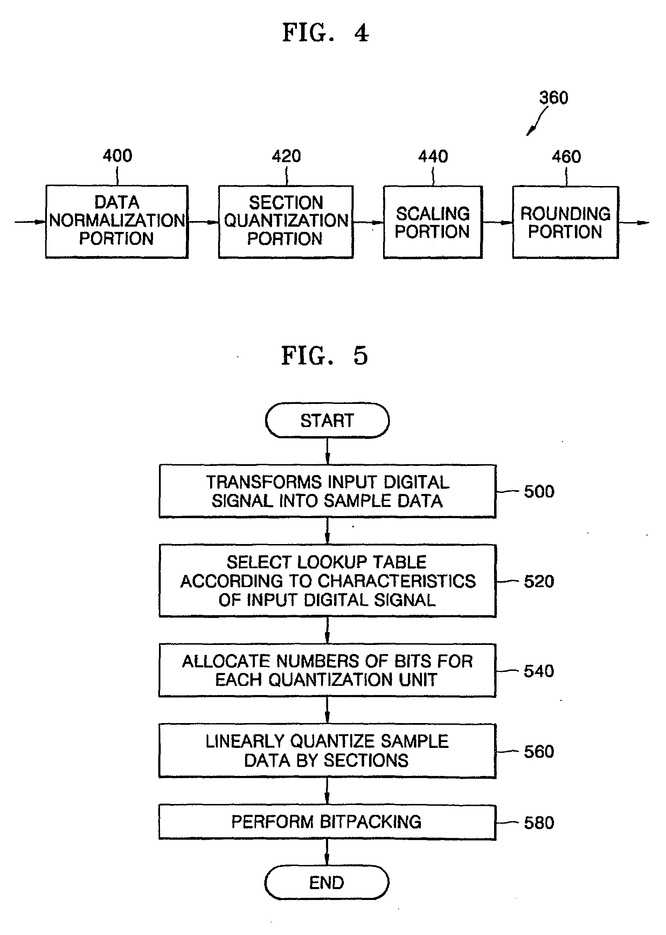

The linear quantization portion 360 divides a distribution of sample data values into predetermined sections based on the quantizing unit, and linearly quantizes sample data from which repeated information is removed by the data transformation portion 300, using the numbers of bits allocated for the quantization units by the bit allocation portion 350. Referring to FIG. 4, the linear quantization portion 360 includes a data normalization portion 400, a section quantization portion 420, a scaling portion 440, and a rounding portion 460.

FIG. 4 is a block diagram of a detailed structure of the linear quantization portion 360. The data normalization portion 400 normalizes the sample data produced by the data transformation portion 300, using a predetermined scale factor. The scale factor is an integer determined by a predetermined function of a value greater than or equal to a maximum absolute value among sample data values within the quantizing unit. The section quantization portion 420 divides the range of normalized values into predetermined sections, and applies linear functions to the predetermined sections of the data normalized by the data normalization portion 400. The scaling portion 440 scales values generated by the section quantization portion 420 using the numbers of bits allocated by the bit allocation portion 350. The rounding portion 460 rounds the scaled sampling values to the nearest whole number using the numbers of bits allocated and generates quantized sample data.

The bit packing portion 370 codes the data linearly quantized by the linear quantization portion 360 to produce a bit stream. The coding may be a Huffman coding.

The digital signal encoding apparatus using the plurality of lookup tables may further include a number-of-bits adjuster (not shown). The number-of-bits adjuster calculates the number of allocated bits for an entire input signal, which is a sum of the numbers of bits allocated to the frequency bands by the bit allocation portion 350, compares the calculated number of allocated bits with a required number of bits to be allocated for the entire input signal, which is determined by an encoding rate required by the encoding apparatus, and adjusts the number of bits allocated to each of the frequency bands according to the comparison result.

FIG. 5 is a flowchart illustrating a digital signal encoding method performed in the digital signal encoding apparatus of FIG. 3. Referring to FIGS. 3 and 5, first, the data transformation portion 300 transforms an input digital signal so that redundant information can be removed from the input digital signal, in operation 500. For example, a time-domain digital input signal is transformed into a predetermined number of frequency bands using sub-band filters, which serve as a band analysis filter.

In operation 520, the bit allocation portion 350 calculates address values of the frequency bands of the input signal, which are quantization units. The address values of the frequency bands indicate characteristics of the frequency bands set as addresses when the lookup tables 320, 330 and 340 are produced. Each of the address values may be a variance of each frequency band, a scale factor of each frequency band, a squared scale factor of each frequency band, a mean value of input signals in each frequency band, a mean power of input signals in each frequency band, a larger value between an occupancy rate of a scale factor of each frequency band and an occupancy rate of a mean value of input signals in each frequency band, or a larger value between an occupancy rate of a squared scale factor of each frequency band and an occupancy rate of a mean power of input signals in each frequency band.

Relations between characteristics of frequency bands, which can be set as the address values of the frequency bands, and the number of allocated bits for each frequency band will now be described. A variance characteristic shows how near a distribution of an input signal is to an average distribution. If the variance is large, a dynamic area of the input signal is large. Accordingly, to reduce quantization noise, more bits must be allocated. If the variance is relatively small, even though the bit allocation amount is small, not as much quantization noise is generated. A mean power characteristic has a similar concept to a mean characteristic. However, because a mean value of an input signal is generally 0 in a case of a sine wave, a mean power value instead of the mean value is used as a characteristic of a frequency band. More bits are allocated to a frequency band whose mean power value is large. A scale factor is defined as a value corresponding to the largest sample value per frequency band, and more bits are allocated to a frequency band whose scale factor is large.

Still in operation 520, the lookup table selection portion 310 selects one of the plurality of lookup tables 320, 330 and 340 according to the characteristic of the input digital signal. The characteristic of the input signal, which is a basis of the lookup table selection, is considered when the plurality of lookup tables 320, 330 and 340 are produced, and may be set to the number of frequency bands among the frequency bands of the input signal, whose occupancy rates are no more than or no less than a predetermined reference value. The occupancy rate of each frequency band may be set to a larger value between an occupancy rate of a scale factor of each frequency band and an occupancy rate of a mean value of input signals in each frequency band or a larger value between an occupancy rate of a squared scale factor of each frequency band and an occupancy rate of a mean power of input signals in each frequency band, which are calculated in Equation 1.

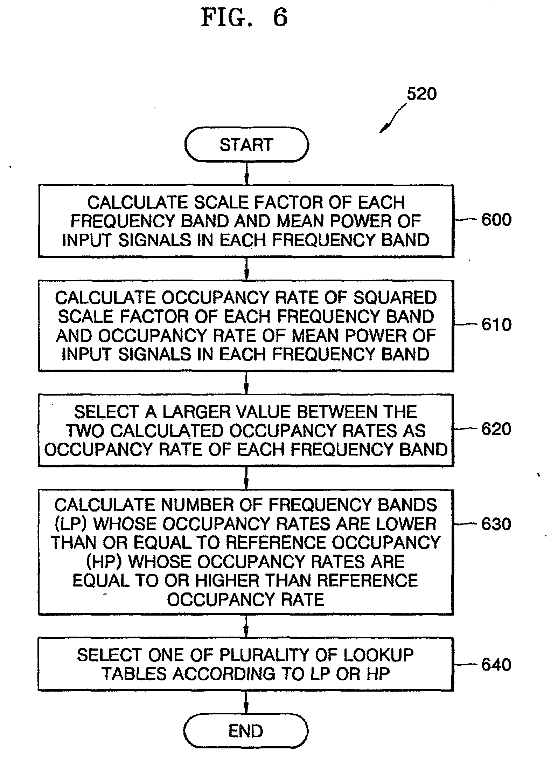

FIG. 6 is a flowchart illustrating an operation of selecting one of the lookup tables illustrated in FIG. 5 (operation 520). Referring to FIG. 6, a scale factor of each frequency band and a mean power of input signals in each frequency band are calculated in operation 600. Then, an occupancy rate of a squared scale factor of each frequency band and an occupancy rate of a mean power of input signals in each frequency band are calculated as shown in Equation 1, in operation 610.

Thereafter, a larger value between the two calculated occupancy rates is selected as an occupancy rate of each frequency band, in operation 620. Next, the number of frequency bands (LP) whose occupancy rates are lower than or equal to a predetermined reference occupancy rate and the number of frequency bands (HP) whose occupancy rates are equal to or higher than the predetermined reference occupancy rate are calculated, in operation 630. The numbers of frequency bands, LP and HP, serve as values indicating the characteristics of the input signal on which the lookup table selection is based.

In operation 640, one of a plurality of lookup tables is selected according to the numbers of frequency bands, LP and HP, which indicate the characteristics of the input signal. If the number of frequency bands, LP, is large, sampled input signals are concentrated in a specific frequency band. Accordingly, a lookup table indicating allocation of more bits for frequency bands where sampled input signals are concentrated is selected. Also, if the number of frequency bands, HP, is small, sampled input signals are concentrated in a specific frequency band. Accordingly, a lookup table indicating allocation of more bits for frequency bands where sampled input signals are concentrated is selected.

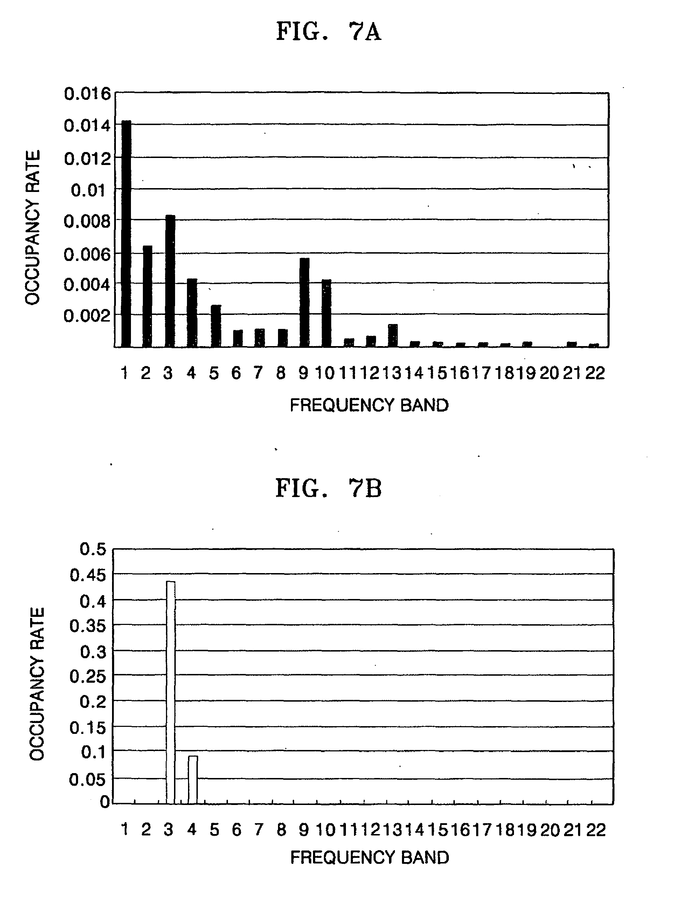

FIGS. 7A and 7B are graphs showing occupancy rates of frequency bands of an input signal. FIG. 7A deals with sampled input signals having a general characteristic. Referring to FIG. 7A, since LP is small and HP is large, a lookup table indicating allocation of similar numbers of bits for all frequency bands is selected.

FIG. 7B deals with sampled input signals which are concentrated in a specific frequency band. Referring to FIG. 7B, since LP is large and HP is small, a lookup table indicating allocation of many bits for a specific frequency band is selected.

After a suitable lookup table is selected according to the characteristics of the input digital signal in operation 520, the bit allocation portion 350 extracts the numbers of allocated bits corresponding to the address values for the frequency bands from the selected lookup table and allocates the numbers of bits to the frequency bands, in operation 540.

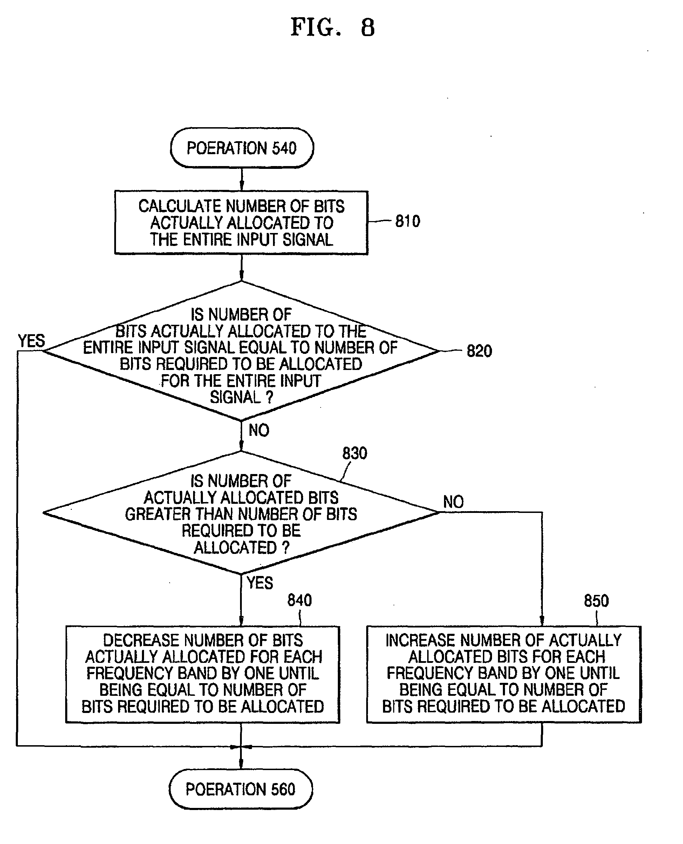

To match the total number of bits allocated for the encoded input signal to the number of bits required to be allocated, which depends on a compression rate, an operation of adjusting the number of bits allocated for each frequency band may be performed after operation 540. This operation will now be described in detail with reference to FIG. 8.

FIG. 8 is a flowchart illustrating an operation of matching a number of bits actually allocated to an input signal to a number of bits required to be allocated to the input signal, after operation 540 of FIG. 5. Referring to FIG. 8, after bits, the number of which is obtained from the selected lookup table, are allocated to each frequency band in operation 540 of FIG. 5, the number of bits actually allocated to the entire input signal is calculated by summing the numbers of bits allocated to the frequency bands, in operation 810.

In operation 820, it is determined whether the number of bits actually allocated to the entire input signal, which is calculated in operation 810, is equal to the number of bits required to be allocated, which depends upon a compression rate for encoding. For example, when the total number of bits for the input signal is 100 and a compression rate is 50%, 50 bits are required to be allocated for the input signal. If the number of bits actually allocated to the entire input signal is equal to the number of bits required to be allocated, bits are allocated to each frequency band according to the numbers of bits allocated in operation 540.

On the other hand, if the number of bits actually allocated to the entire input signal is different from the number of bits required to be allocated, another determination is made as to whether the number of actually allocated bits is greater than the number of bits required to be allocated, in operation 830. If the number of actually allocated bits is greater than the number of bits required to be allocated, the number of actually allocated bits for each frequency band decreases 1 until being equal to the number of bits required to be allocated, in operation 840. If the number of actually allocated bits is smaller.than the number of bits required to be allocated, the number of actually allocated bits for each frequency band increases 1 until being equal to the number of bits required to be allocated, in operation 850.

Referring back to FIG. 5, when the number of bits to be allocated for each frequency band is finally determined, the distribution of digital signal values for each quantization unit, for example, each frequency band obtained when using sub-band filters, is divided into predetermined sections, and the digital signal values in each section are linearly quantized using the number of bits to be allocated for each quantization unit, in operation 560.

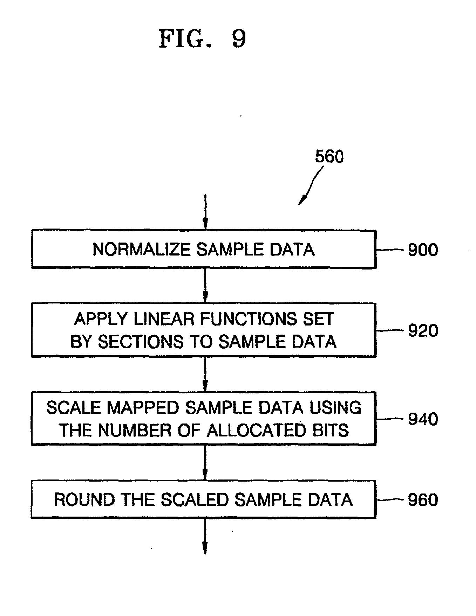

FIG. 9 is a flowchart illustrating operation 560 shown in FIG. 5. Referring to FIGS. 4 and 9, first, the data normalization portion 400 normalizes sample data obtained by the data transformation portion 300, using a scale factor of each quantization unit, that is, each frequency band obtained when using sub-band filters, in operation 900. For example, assume that the output sample values that are sub-band filtered using the subband filters of the data transformation portion 300 are 24, -32, 4, and 10. The maximum absolute value of the output sample values is 32. When the sample values are normalized using a scale factor corresponding to the maximum value 32, the sample values become 0.75, -1, 0.125, and 0.3125. Here, the scale factor may be determined as follows. In a predetermined formula $2^{x/4}$, wherein x is a scale factor, when x is incremented by one from 0 to 31, the value of the formula $2^{x/4}$ is determined according to 32 values of x. That is, if x=0, the value of the formula $2^{x/4}$ is 1, if x=1, the value of the formula $2^{x/4}$ is 1.18, if x=2, the value of the formula $2^{x/4}$ is 1.414, if x=3, the value of the formula $2^{x/4}$ is 1.68, if x=4, the value of the formula $2^{x/4}$ is 2, etc. When all the values of the formula $2^{x/4}$ are calculated, it can be seen that as x increments by one, the value of the formula $2^{x/4}$ increments by 1.5dB. In the present example, if the value of the formula $2^{x/4}$ corresponding to the absolute maximum value 32 is 32, the scale factor x will be 20. Therefore, one value of the scale factor is determined in each subband.

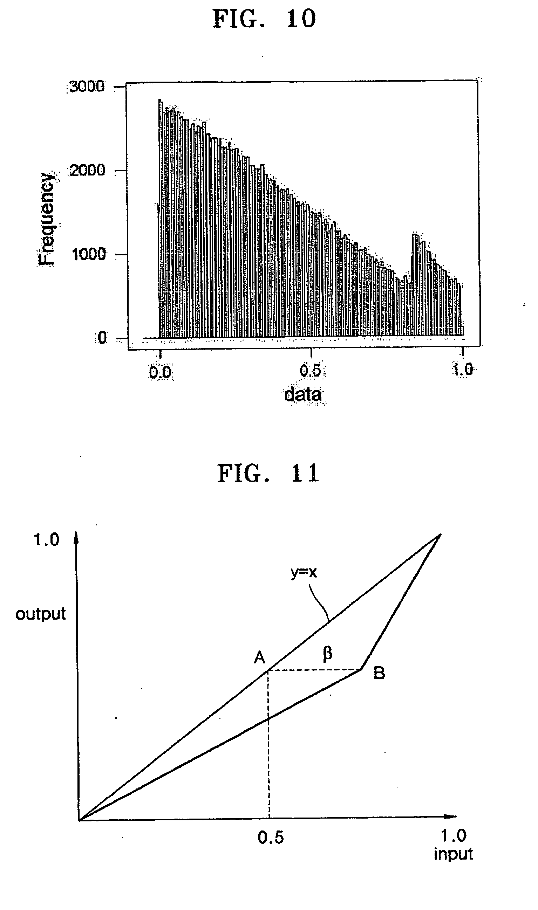

FIG. 10 is a graph illustrating the distribution of subband samples used to normalize the sample data. The normalized samples, as shown in FIG. 10, are not uniformly distributed. Therefore, they cannot be optimally quantized using a linear quantizer.

Therefore, the section quantizing portion 420 divides the range of the normalized values into predetermined sections and transforms the sample data normalized in operation 900 by applying linear functions set for the predetermined sections to the sample data, in operation 920. For example, the range of the normalized values in FIG. 10 is 0.0-1.0, and FIG. 11 illustrates the normalized value range divided into two sections. In the graph of FIG. 11 illustrating a linear function given by y=x, a point away from a point A on the graph y=x corresponding to the mid point (x=0.5) on the x-axis by β in the x-axis direction is indicated by B. Thus, if β is 0.1, the x-axis is divided into two sections: one section from 0-0.6 (section1) and the other section from 0.6 to 1.0 (section 2). Two linear functions are applied to the two sections in such a way that one linear function is applied to one section. The value of β may be set according to the distribution of samples. β indicates how much the linear function y=x at the middle point of the normalized value range is inclined with respect to the x-axis. In another form, β may indicate how much the linear function y=x at the middle point of the normalized value range is inclined with respect to the y-axis.

The linear functions can generally be expressed as $y = \dfrac{ax}{(a - 2b)}$ and $y = \dfrac{x}{(1 + 2b)} + \dfrac{2b}{(1 + 2b)}$. Here, a denotes the range of normalized values, and b denotes section displacement from the center of a. In the present example, if the β is 0.1, a first linear function $y = f_1(x)$ is $y = \dfrac{5}{6} \times x$ in section 1, and a second linear function $y = f_2(x)$

is $y = \dfrac{5}{4}x - \dfrac{1}{4}$ in section 2. The linear functions are applied to sample values in the corresponding sections. In the present example, the sample values 0.125 and 0.3125 are included in section 1 and mapped by applying the first linear function $y=f_1(x)$, and the sample values 0.75 and -1 are included in section 2 and mapped by applying the second linear function $y=f_2(x)$.

In operation 940, the mapped values are scaled in the scaling portion 440 using the number of bits allocated by the bit allocating portion 350. For example, if the bit allocation information is 3, the sample values mapped by applying the linear functions of the corresponding sections are multiplied by 8, since 0 through 7 can be expressed.

In operation 960, the sample values scaled in operation 940 are rounded to obtain quantized sample values. The rounded value is always an integer. For example, if the number of bits to be allocated is 3, a rounded value is one from 0 to 7, is expressed with 3 bits, and is the final quantized sample value.

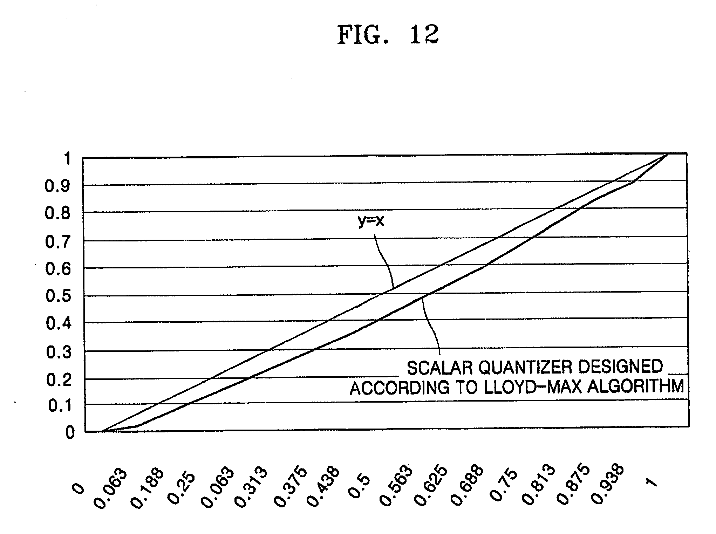

FIG. 12 is a graph produced using a quantizer designed according to a Lloyd-Max algorithm based on the distribution of FIG. 10. As illustrated in FIG. 12, the produced graph bulges downwards toward the x-axis from the linear function y=x.

Referring back to FIG. 5, in operation 580, the data linearly quantized as described above together with side information is encoded into a bit stream using a data encoding method, such as, a Huffman encoding, in the bit packing portion 370 of FIG. 3. Preferably, the side information includes a scale factor of each frequency band and the number of bits allocated for each frequency band.

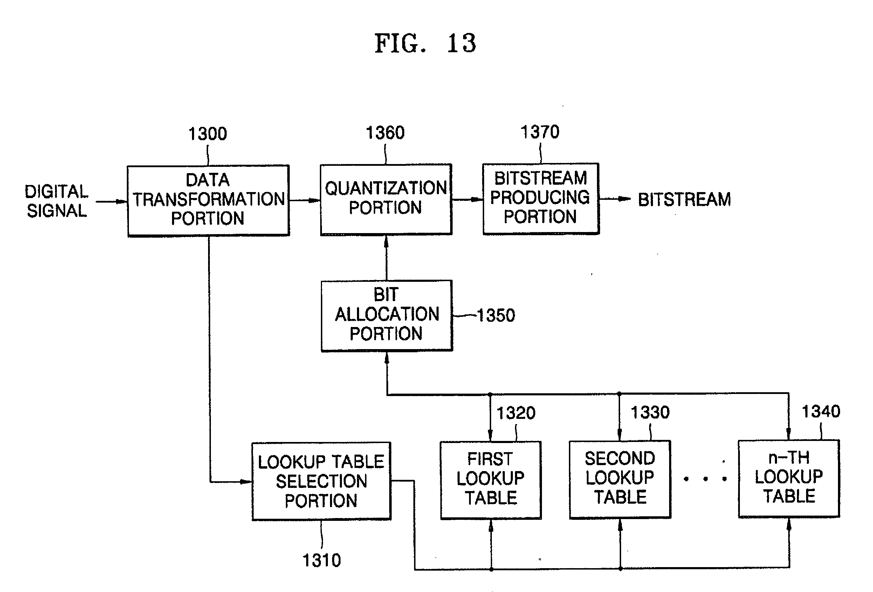

Hereinafter, a digital signal encoding apparatus having improvements in a bit allocation portion and a bit packing portion will be described with reference to FIG. 13. Referring to FIG. 13, this digital signal encoding apparatus includes a data transformation portion 1300, a lookup table selection portion 1310, a plurality of lookup tables 1320, 1330, and 1340, a bit allocation portion 1350, a quantization portion 1360, and a bitstream producing portion 1370.

The data transformation portion 1300, the lookup table selection portion 1310, the lookup tables 1320, 1330, and 1340, and the bit allocation portion 1350 operate equally to the data transformation portion 300, the lookup table selection portion 310, the lookup tables 320, 330, and 340, and the bit allocation portion 350 of FIG. 3, respectively, so they will not be described again.

The quantization portion 1360, which is a general quantizer, quantizes the input signal using bits allocated for each quantization unit, e.g., each frequency band when using sub-band filters.

The bitstream producing portion 1370 produces a bitstream comprised of frames from the quantized data and side information. Information about a frame length is located at a tail portion of the bitstream. Preferably, the side information includes a scale factor for each frequency band and the number of bits allocated for each frequency band.

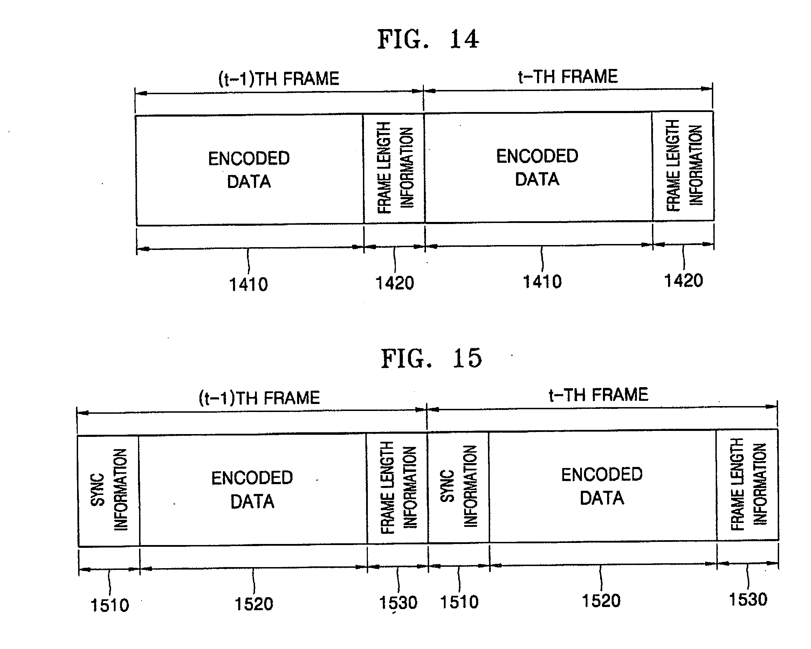

FIG. 14 illustrates an example of a frame structure of a bitstream. Each frame is comprised of a first area 1410, which stores encoded data, and a second area 1420, which stores encoded information about a frame length. A size of the second area 1420 is constant for all frames, and a size of the first area 1410 may vary when an encoding rate of frames is a variable bitrate. FIG. 15 illustrates another example of a frame structure of a bitstream. Each frame is comprised of a first area 1510, which stores sync information, a second area 1520, which stores encoded data, and a third area 1530, which stores encoded information about a frame length. Sizes of the first and third area 1510 and 1530 are constant for all frames, and a size of the second area 1520 may vary when an encoding rate of frames is a variable bitrate. When a frame includes sync information as in the example of FIG. 15, and a digital signal reproducing apparatus receives an external impact during reproduction of a digital signal, a reverse search for effective data to be reproduced can become more reliable and more accurate.

The digital signal encoding apparatus of FIG. 13 may further include a number-of-bits adjusting portion (not shown). The number-of-bits adjusting portion calculates the number of allocated bits for an entire input signal, which is a sum of the numbers of bits allocated to the frequency bands by the bit allocation portion 1350, compares the calculated number of allocated bits with a required number of bits to be allocated for the entire input signal, which is determined by an encoding rate required by the encoding apparatus, and adjusts the number of bits allocated for each of the frequency bands according to the comparison result.

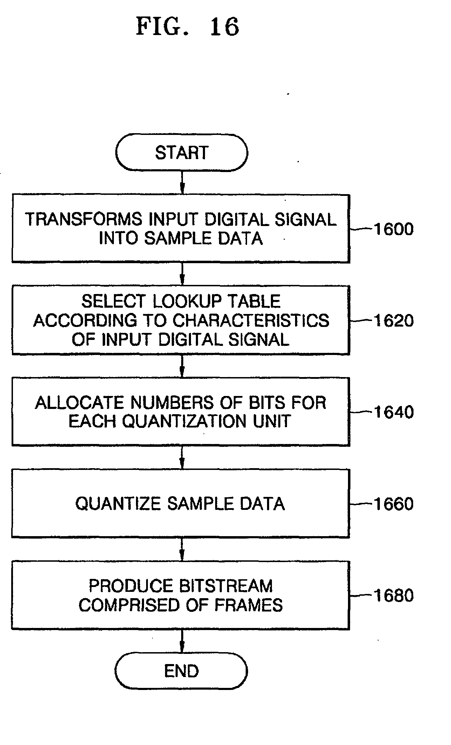

FIG. 16 is a flowchart illustrating a digital signal encoding method in which a bit stream including frame length information is produced using a plurality of lookup tables. This digital signal encoding method will now be described by referring to FIGS. 13 and 16.

Operations 1600 through 1640 are the same as operations 500 through 540 of FIG. 5, so they will not be described herein.

To match the total number of bits allocated for the encoded input signal to a required number of bits to be allocated, which depends on a compression rate, an operation of comparing the total number of bits allocated for the encoded input signal with the required number of bits to be allocated and adjusting the number of bits allocated for each frequency band according to a result of the comparison may be performed after operation 1640.

After bits are allocated to each frequency band in operation 1640 or after the number of bits allocated to each frequency band is adjusted as necessary, data transformed by the data transformation portion 1300 is quantized, for example, in units of a frequency band when using sub-band filters, using the number of bits allocated to each frequency band, in operation 1660.

Thereafter, a bitstream comprised of frames is produced from the quantized data and predetermined side information in the bitstream producing portion 1370, in operation 1680. Each frame in a bitstream includes information about a frame length located in a tail area of the frame as shown in FIG. 14 and may further include sync information used for inter-frame synchronization located in a head area of the frame as shown in FIG. 15. Preferably, the predetermined side information includes a scale factor of each band and the number of bits allocated for each band.

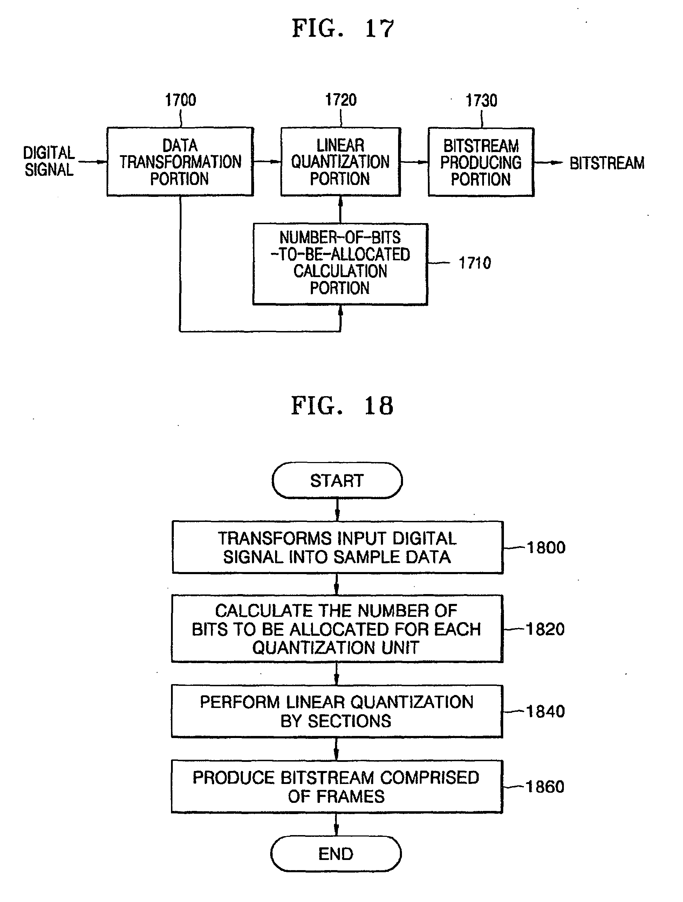

FIG. 17 is a block diagram of a digital signal encoding apparatus having improvements in a linear quantization portion and a bit packing portion. This digital signal encoding apparatus includes a data transformation portion 1700, a number-of-bits-to-be-allocated calculation portion 1710, a linear quantization portion 1720, and a bitstream production portion 1730.

The data transformation portion 1700 and the linear quantization portion 1720 operate equally to the data transformation portion 300 and the linear quantization portion 360 of FIG. 3, respectively, and the bitstream production portion 1730 operates equally to the bitstream production portion 1370 of FIG. 13. Accordingly, the data transformation portion 1700, the linear quantization portion 1720, and the bitstream production portion 1730 will not be described herein.

The number-of-bits-to-be-allocated calculation portion 1710 is the same as a bit allocation portion of a general digital signal encoding apparatus. In other words, the number-of-bits-to-be-allocated calculation portion 1710 calculates the number of bits to be allocated for each quantization unit in consideration of the importance of a signal. Also, the number-of-bits-to-be-allocated calculation portion 1710 omits detailed information lowly sensitive to humans using hearing characteristics of humans and differentiates the numbers of bits to be allocated for frequency bands so that the amount of data to be encoded can be reduced. Preferably, the number-of-bits-to-be-allocated calculation portion 1710 calculates the numbers of bits to be allocated for frequency bands, in consideration of the psychoacoustic perspective.

FIG. 18 is a flowchart illustrating a digital signal encoding method in which a bit stream including frame length information is produced using linear quantization by sections. This digital signal encoding method will now be described with reference to FIGS. 17 and 18.

Operations 1800 and 1840 of FIG. 18 are the same as operations 500 and 540 of FIG. 5, and operation 1860 of FIG. 18 is the same as operation 1680 of FIG. 16. Hence, operations 1800, 1840, and 1860 will not be described in detail herein. When a digital audio signal is transformed so that redundant information is removed from the digital signal in operation 1800, the number-of-bits-to-be-allocated calculation portion 1710 calculates the number of bits to be allocated for each quantization unit considering the importance of the audio signal, in operation 1820. For example, the quantization unit may be a sub-band when using sub-band filters. The importance of the digital signal, particularly, the audio signal, is decided considering the psychoacoustic perspective based on hearing characteristics of humans. Therefore, more bits are allocated to frequencies to which humans are highly sensitive and fewer bits are allocated to rest of the frequencies.

After the number of bits to be allocated for each frequency band is calculated in 1820, linear quantization by sections is performed in operation 1840, and a bitstream including information about a frame length is produced in operation 1860.

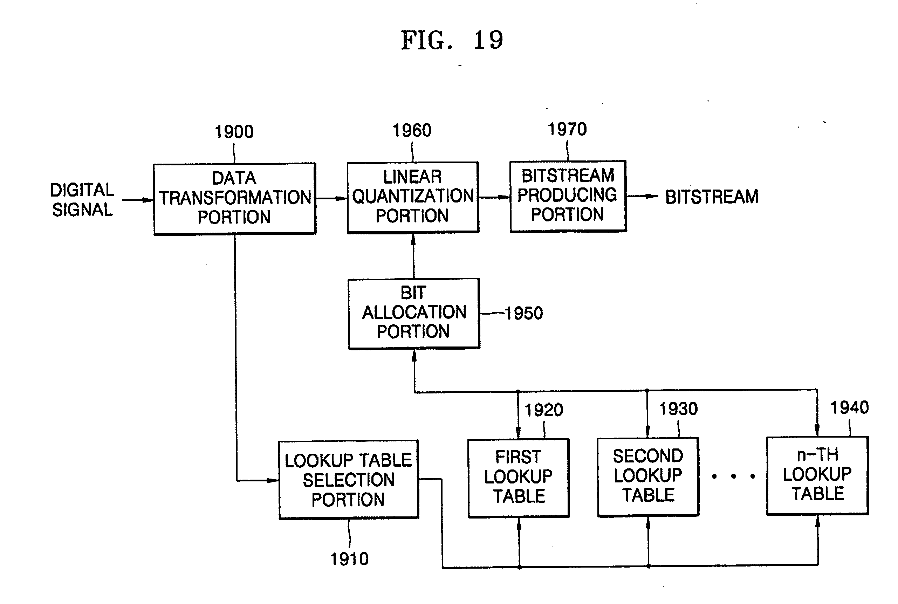

FIG. 19 is a block diagram of a digital signal encoding apparatus having improvements in a lookup table, a bit allocation portion, and a bit packing portion. This digital signal encoding apparatus includes a data transformation portion 1900, a lookup table selection portion 1910, a plurality of lookup tables 1920, 1930, and 1940, a bit allocation portion 1950, a linear quantization portion 1960, and a bitstream producing portion 1970.

The data transformation portion 1900, the lookup table selection portion 1910, the lookup tables 1920, 1930, and 1940, the bit allocation portion 1950, and the linear quantization portion 1960 are the same as the data transformation portion 300, the lookup table selection portion 310, the lookup tables 320, 330, and 340, the bit allocation portion 350, and the linear quantization portion 360 of FIG. 3, respectively, in their functions and operations. The bitstream producing portion 1970 is the same as the bit packing portion 1370 of FIG. 13 in its function and operation. Hence, these elements of the digital signal encoding apparatus of FIG. 19 will not be described herein.

The digital signal encoding apparatus of FIG. 19 may include the above-described number-of-bits adjusting portion (not shown). The number-of-bits adjusting portion calculates the number of allocated bits for an entire input signal, which is a sum of the numbers of bits allocated to the frequency bands by the bit allocation portion 1950, compares the calculated number of allocated bits with a required number of bits to be allocated for the entire input signal, which is determined by an encoding rate required by the encoding apparatus, and adjusts the number of bits allocated for each of the frequency bands according to the comparison result.

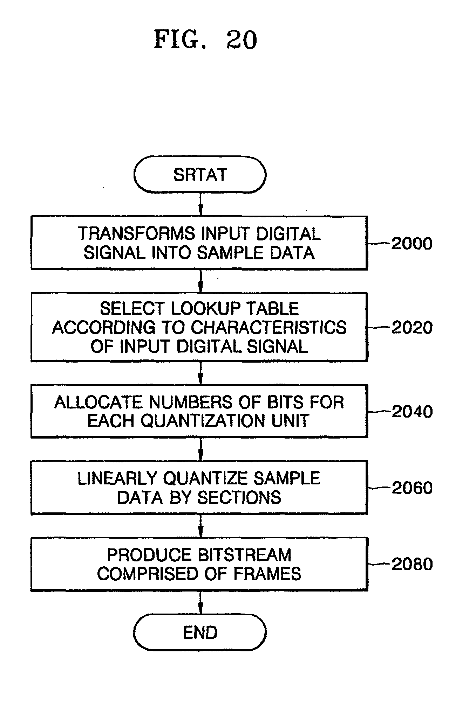

FIG. 20 is a flowchart illustrating a digital signal encoding method in which a bit stream including frame length information is produced using a plurality of lookup tables and linear quantization by sections. This digital signal encoding method will now be described with reference to FIGS. 13 and 20. Operations 2000 through 2060 of FIG. 20 are the same as operations 500 through 560 of FIG. 5, respectively, and operation 2080 is the same as operation 1680 of FIG. 16, so they will not be described in detail herein. To match the total number of bits allocated for the encoded input signal to a required number of bits to be allocated, which depends on a compression rate, an operation of comparing the total number of bits allocated for the encoded input signal with the required number of bits to be allocated and adjusting the number of bits allocated for each frequency band according to a result of the comparison may be performed after operation 2040.

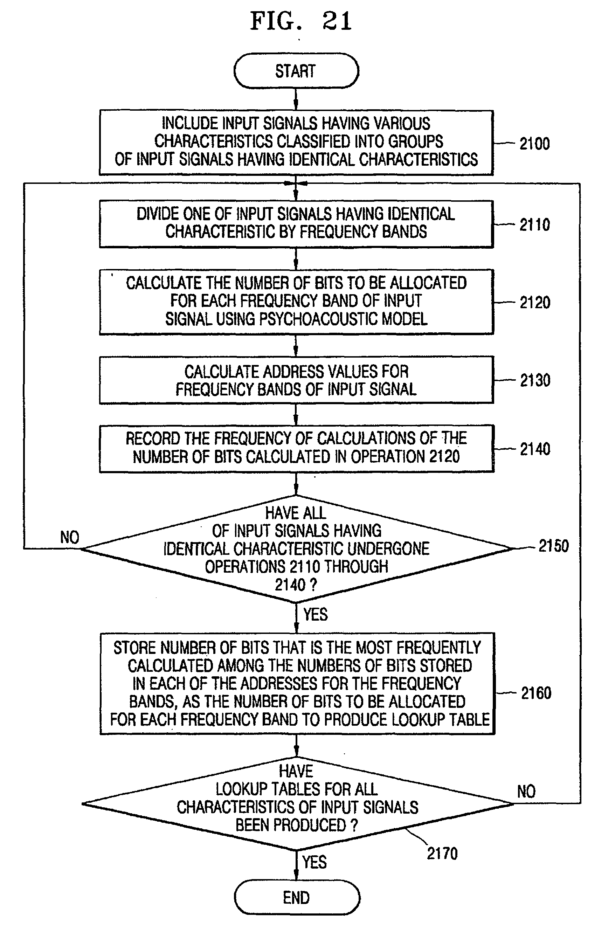

FIG. 21 is a flowchart illustrating a method of producing the plurality of lookup tables. As illustrated in FIG. 21, a predetermined number of input signals having various characteristics are classified into groups of input signals having identical characteristics, in operation 2100. The characteristics of the input are the same as in the above description of the lookup tables.

In operation 2110, one of the characteristics of the input signals is selected, and one of input signals having the selected characteristic is divided by frequency bands. In operation 2120, the number of bits to be allocated for each frequency band of the input signal is calculated using a psychoacoustic model. The calculation of the number of bits to be allocated for each frequency band in operation 2120 is the same as an operation of the psychoacoustic model 110 of FIG. 1, so it will not be described herein.

In operation 2130, address values for the frequency bands of the input signal are calculated. The address values are set to values indicating characteristics of the frequency bands of the input signal. The address values are the same as in the above description of the lookup tables.

In operation 2140, the numbers of bits to be allocated to the frequency bands calculated in operation 2120 are stored in addresses corresponding to the address values of the frequency bands calculated in operation 2130, and the frequency of calculations of the stored number of bits to be allocated for each frequency band is recorded.

In operation 2150, it is determined whether all of the input signals having the selected characteristic have undergone operations 2110 through 2140. If all of the input signals having the selected characteristic have not yet undergone operations 2110 through 2140, operations 2110 through 2140 are repeated.

On the other hand, if all of the input signals having the selected characteristic have undergone operations 2110 through 2140, a number of bits to be allocated that is the most frequently calculated among the numbers of bits stored in the addresses for each frequency band is stored as the number of bits to be allocated for each frequency band to produce a lookup table, in operation 2160. After operation 2160, addresses which record 0 as the number of bits allocated may be excluded from the produced lookup table. Also, when identical numbers of allocated bits are recorded in consecutive addresses, only addresses where different numbers of allocated bits are recorded may be stored in a lookup table to produce a small-sized lookup table.

In operation 2170, it is determined whether lookup tables for all characteristics of the input signals have been produced. If all of the lookup tables have not yet been produced, operations 2110 through 2160 are repeated until all of the lookup tables are produced.

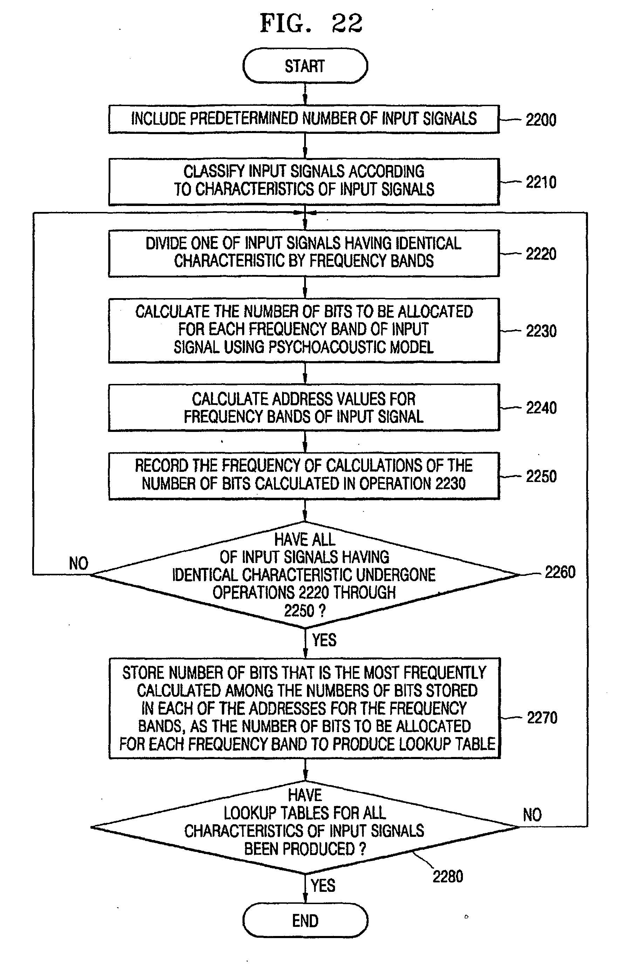

FIG. 22 is a flowchart illustrating a method of producing a plurality of looku p tables. Referring to FIG. 22, a predetermined number of input signals having various characteristics are included in operation 2200. The input signals are classified according to the characteristics of the input signals, in operation 2210. The characteristics of the input signals are the same as in the description of the lookup tables. Operations 2220 through 2280 of FIG. 22 are the same as operation 2110 through 2170 of FIG. 21.

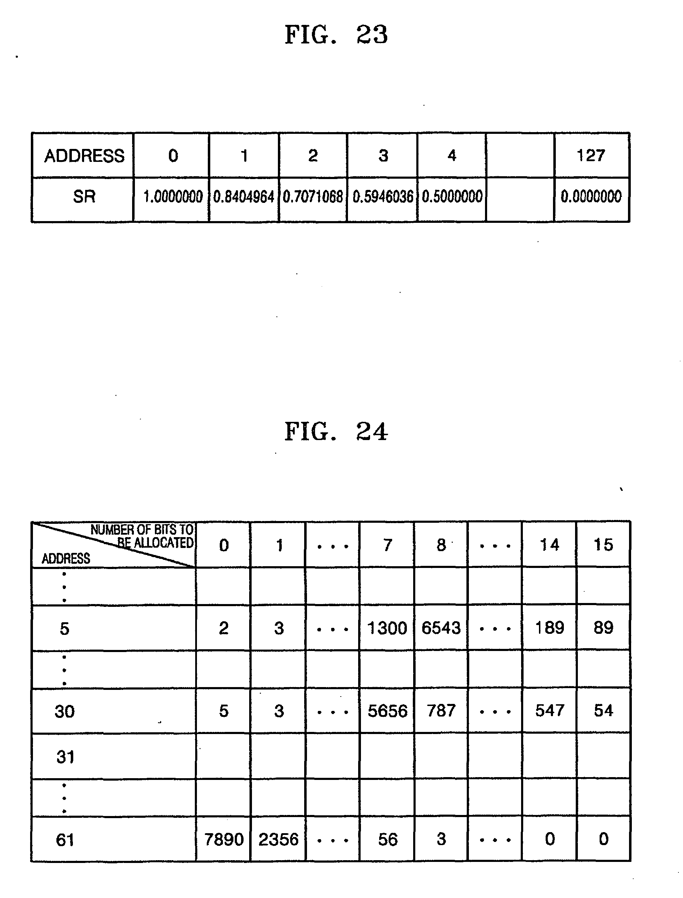

FIG. 23 is a table illustrating a method of setting addresses used in a lookup table. Referring to FIG. 23, a larger value between an occupancy rate of a squared scale factor of each frequency band and an occupancy rate of a mean power of each frequency band is used as each address of a lookup table. The occupancy rates used as the addresses of the lookup table range between 0 and 1. The occupancy rates between 0 and 1 are divided into 127 addresses.

FIG. 24 is a table illustrating a method of producing a lookup table. The method of FIG. 24 is operation 2160 of FIG. 21 or operation 2270 of FIG. 22, in which a lookup table is produced using the frequency of calculations of the stored number of bits allocated for each frequency band. Referring to FIG. 24, the number of bits allocated for each address for each frequency band is stored to produce a lookup table. In address 5 of the lookup table, the number of allocated bits, 8, which was calculated the most frequently among the stored numbers of allocated bits for the address 5, is stored as a final number of bits to be allocated. In address 30 of the lookup table, the number of allocated bits, 7, which was calculated the most frequently among the stored numbers of allocated bits for the address 30, is stored as a final number of bits to be allocated. In address 61 of the lookup table, the number of allocated bits, 0, which was calculated the most frequently among the stored numbers of allocated bits for the address 61, is stored as a final number of bits to be allocated. To reduce a volume of the lookup table, addresses which record 0 as the number of bits allocated may be excluded from a lookup table to be produced. Also, when identical numbers of allocated bits are recorded in consecutive addresses, only addresses that record different numbers of allocated bits may be stored in the lookup table.

Decoding apparatuses corresponding to the encoding apparatuses will now be described.

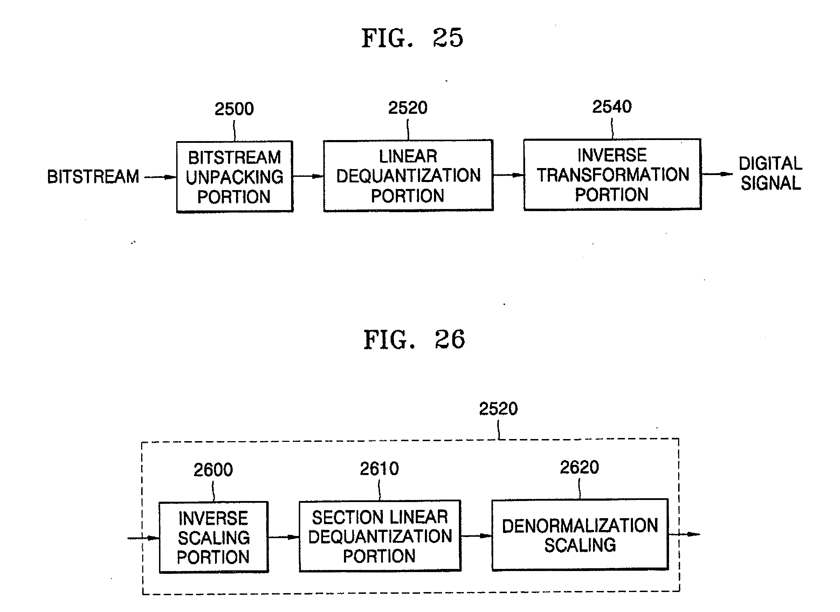

FIG. 25 is a block diagram of a digital signal decoding apparatus corresponding to the digital signal encoding apparatus in which linear quantization by sections is performed using a plurality of lookup tables. This digital signal decoding apparatus is comprised of a bitstream unpacking portion 2500, a linear dequantization portion 2520, and an inverse transformation portion 2540.

The bitstream unpacking portion 2500 extracts linearly quantized data and side information from a bitstream into which a digital signal is encoded. For example, when the bitstream is an audio signal bitstream, quantized sample data and side information are extracted.

The linear dequantization portion 2520 dequantizes the linearly quantized data on a section-by-section basis using the side information extracted by the bitstream unpacking portion 2500. The section corresponds to a section set upon quantization for encoding. If the section for quantization is set based on an input axis of the graph of FIG. 11 upon encoding, the section for dequantization is set based on an output axis of the graph of FIG. 11 upon decoding.

The inverse transformation portion 2540 inversely transforms the dequantized data obtained by the linear dequantization portion 2520 into the digital signal, preferably, PCM data. The inverse transformation is an inverse transformation of the transformation used upon encoding. When a band-split filter is used as a sub-band filter upon transformation, the inverse transformation portion 2540 uses a band-synthesis filter.

FIG. 26 is a block diagram of a detailed structure of the linear dequantization portion 2520. The linear dequantization portion 2520 is comprised of an inverse scaling portion 2600, a section linear dequantization portion 2610, and a denormalization portion 2620.

The inverse scaling portion 2600 inverse scales the sample data that are linearly quantized in sections, using bit allocation information included in the side information extracted by the bitstream unpacking portion 2500. The inverse scaling corresponds to the scaling used for quantization. For example, if 4 bits are allocated for encoding and the sample data was multiplied by 15, then the sample data is divided by 15 for decoding.

The section linear dequantization portion 2610 linear dequantizes the inverse-scaled data for each section. The denormalization portion 2620 denormalizes the data dequantized by the section linear dequantization portion 2610 using an inverse scale factor that corresponds to the scaling factor used for quantization.

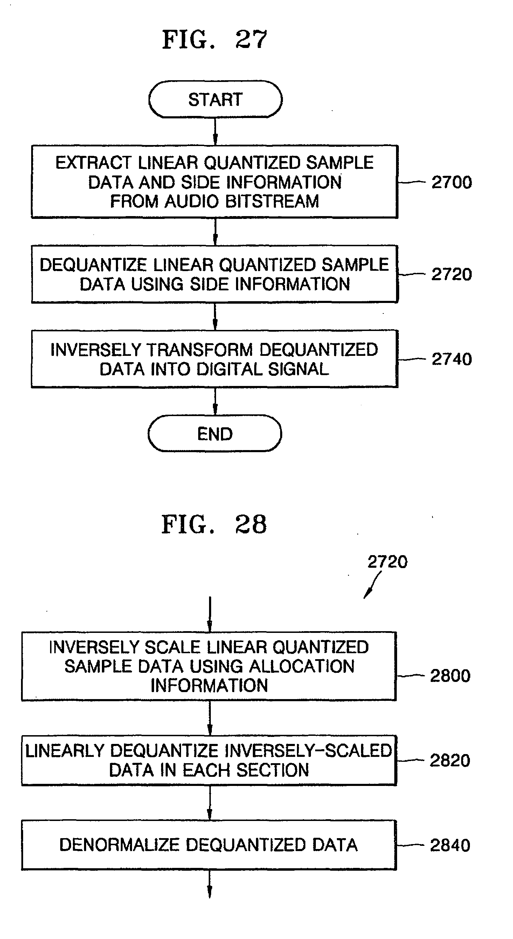

FIG. 27 is a flowchart illustrating a digital signal decoding method corresponding to the digital signal encoding method in which linear quantization by sections is performed using a plurality of lookup tables. Referring to FIGS. 25 and 27, first, when a bit stream of a digital signal, which may be an audio digital signal, is input to the bitstream unpacking portion 2500, quantized sample data and side information are extracted from the audio bitstream, in operation 2700.

In operation 2720, the sample data that is linearly quantized by sections, is dequantized by sections using the side information by the linear dequantization portion 2520. The sections for dequantization correspond to the sections divided for the linear quantization (e.g., if the sections for quantization were divided with respect to the input-axis illustrated in FIG. 11 for encoding, then the sections are divided with respect to the output-axis for decoding). Afterwards, the dequantized data is inversely transformed into the digital signal, preferably PCM data, in operation 2740. This inverse transformation is the inverse of the transformation used for encoding.

FIG. 28 is a flowchart illustrating operation 2720 of dequantizing the sample data. Referring to FIGS. 25 and 28, the sample data that are linearly quantized by sections is scaled inversely to the scaling used for quantization by the inverse scaling portion 2600 using the bit allocation information, in operation 2800. Afterwards, the inversely scaled data is linearly dequantized in each section in the section linear dequantization portion 2610, in operation 2820. The dequantized data is then denormalized by the denormalization portion 2620 by using an inverse scale factor that corresponds to the scaling factor used for quantization, in operation 2840.

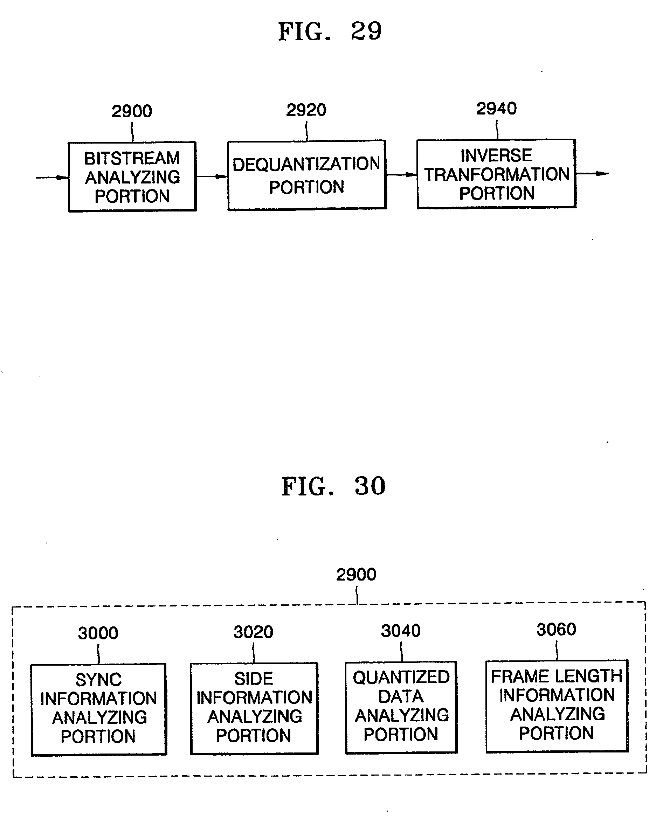

FIG. 29 is a block diagram of a digital signal decoding apparatus corresponding to the digital signal encoding apparatus in which a bit stream including frame length information is produced using a plurality of lookup tables. This digital signal decoding apparatus is comprised of a bitstream analyzing portion 2900, a dequantization portion 2920, and an inverse transformation portion 2940. The bitstream analyzing portion 2900 extracts side information, quantized data, and frame length information from a bitstream of a digital signal. If the bitstream is an audio signal bitstream, quantized sample data, side information, and frame length information are extracted. The bitstream analyzing portion 2900 also extracts sync information if the bitstream further includes sync information.

FIG. 30 is a block diagram of the bit stream analyzing portion 2900, which is comprised of a synch information analyzing portion 3000, a side information analyzing portion 3020, a quantized data analyzing portion 3040, and a frame length information analyzing portion 3060.

The synch information analyzing portion 3000 extracts the sync information from the bitstream of the digital signal. The side information analyzing portion 3020 extracts the side information from the bitstream. The quantized data analyzing portion 3040 extracts the quantized data from the bitstream. The frame length information analyzing portion 3060 extracts the frame length information from the bitstream.

Referring back to FIG. 29, the dequantization portion 2920 dequantizes the extracted quantized data using the side information extracted by the bitstream analyzing portion 2900.

The inverse transformation portion 2940 transforms the data dequantized by the dequantization portion 2920 into the digital signal, preferably, PCM data, using an inverse transformation of a transformation used for encoding. If a band-split filter was used as a sub-band filter upon transformation, a band-synthesis filter is used as the inverse transformation portion 2940.

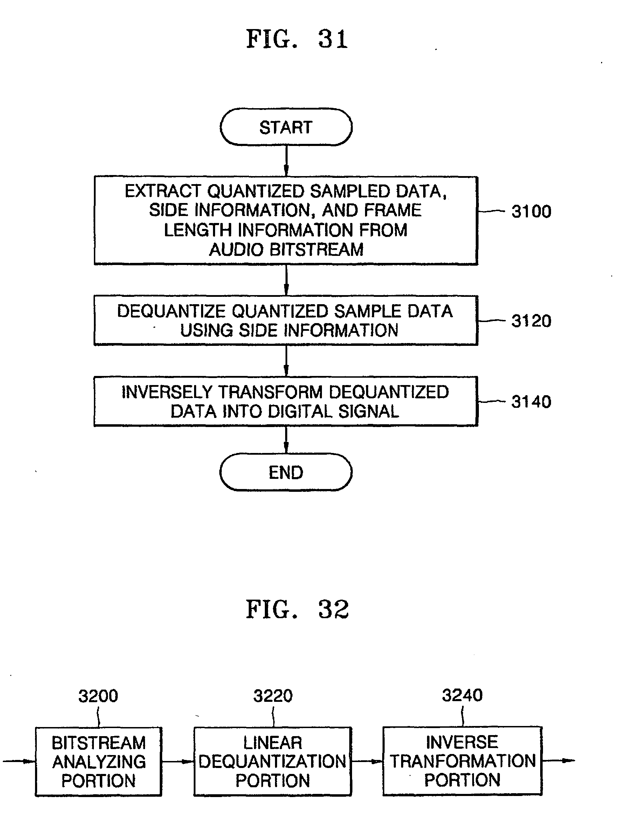

FIG. 31 is a flowchart illustrating a digital signal decoding method corresponding to the digital signal encoding method in which a bit stream including frame length information is produced using a plurality of lookup tables.

Referring to FIGS. 29 and 31, first, when a bitstream, which may be an audio bitstream, of a digital signal is input to the bitstream analyzing portion 2900, quantized sampled data, side information, and frame length information are extracted from the audio bitstream, in operation 3100. If sync information is included in the bitstream, it is also extracted from the bitstream.

In operation 3120, the dequantization portion 2920 dequantizes the quantized sample data using the side information. Thereafter, in operation 3140, the dequantized data is transformed inversely to the transformation used for encoding to produce the digital signal, which may be PCM data.

FIG. 32 is a block diagram of a digital signal decoding apparatus corresponding to a digital signal encoding apparatus in which a bit stream including frame length information is produced using a plurality of lookup tables and linear quantization by sections and to a digital signal encoding apparatus in which a bit stream including frame length information is produced using linear quantization by sections. This digital signal decoding apparatus is comprised of a bitstream analyzing portion 3200, a linear dequantization portion 3220, and an inverse transformation portion 3240.

The bitstream analyzing portion 3200 extracts side information, quantized data, and frame length information from a bitstream of a digital signal. If the bitstream is an audio signal bitstream, quantized sample data, side information, and frame length information are extracted. The bitstream analyzing portion 3200 also extracts sync information if the bitstream further includes the sync information.

The bit stream analyzing portion 3200 has the same structure as that of the bitstream analyzing portion 2900 illustrated in FIG. 30. Accordingly, the bit stream analyzing portion 3200 is comprised of the synch information analyzing portion 3000, the side information analyzing portion 3020, the quantized data analyzing portion 3040, and the frame length information analyzing portion 3060. The synch information analyzing portion 3000 extracts the sync information from the bitstream of the digital signal. The side information analyzing portion 3020 extracts the side information from the bitstream. The quantized data analyzing portion 3040 extracts the quantized data from the bitstream. The frame length information analyzing portion 3060 extracts the frame length information from the bitstream.

The linear dequantization portion 3220 dequantizes the data which is linearly quantized by sections, by sections corresponding to the sections divided for the linear quantization, using the side information extracted by the bitstream analyzing portion 3200. If the sections for the linear quantization are set based on the input axis of the graph of FIG. 11 upon encoding, the sections for the linear dequantization are set based on the output axis of the graph of FIG. 11 upon decoding.

The linear dequantization portion 3220 has the same structure as the structure of the linear dequantization portion 2520 illustrated in FIG. 26. Accordingly, the linear dequantization portion 3220 is comprised of the inverse scaling portion 2600, the section linear dequantization portion 2610, and the denormalization portion 2620. The inverse scaling portion 2600 inversely scales the sample data that are linearly quantized in sections, using bit allocation information included in the side information extracted by the bitstream unpacking portion 2500. The inverse scaling corresponds to the scaling used for quantization. For example, if 4 bits are allocated for encoding and the sample data was multiplied by 15, then the sample data is divided by 15 for decoding.

The section linear dequantization portion 2610 linear dequantizes the inverse-scaled data for each section. The denormalization portion 2620 denormalizes the data dequantized by the section linear dequantization portion 2610 using an inverse scale factor that corresponds to the scaling factor used for quantization.

Referring back to FIG. 32, the inverse transformation portion 3240 transforms the data dequantized by the linear dequantization portion 3220 into the digital signal, preferably, PCM data, using an inverse transformation of a transformation used for encoding. If a band-split filter was used as a sub-band filter upon transformation, a band-synthesis filter is used as the inverse transformation portion 3240.

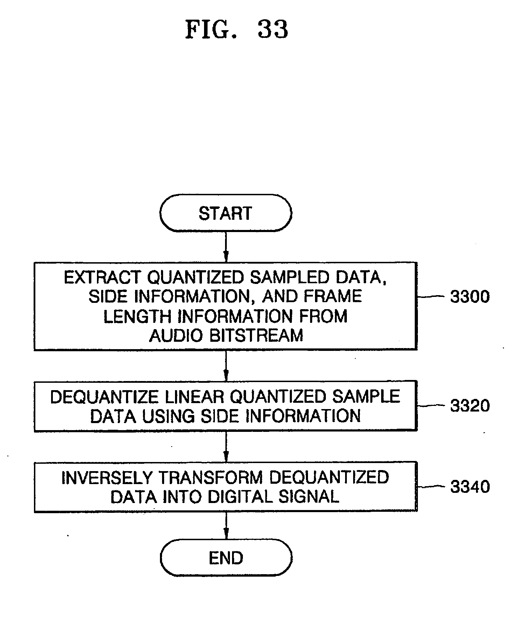

FIG. 33 is a flowchart illustrating a digital signal decoding method corresponding to the digital signal encoding method in which a bit stream including frame length information is produced using a plurality of lookup tables and linear quantization by sections and to a digital signal encoding method in which a bit stream including frame length information is produced using linear quantization by sections.

Referring to FIGS. 32 and 33, first, when a bitstream, which may be an audio bitstream, of a digital signal is input to the bitstream analyzing portion 3200, side information, quantized sampled data, and frame length information are extracted from the audio bitstream by the side information analyzing portion 3020, the quantized data analyzing portion 3040, and the frame length information analyzing portion 3060 of the bitstream analyzing portion 3200, respectively, in operation 3300. If sync information is included in the bitstream, it is also extracted from the bitstream by the sync information analyzing portion 3000 of the bitstream analyzing portion 3200.

In operation 3320, the sample data that is linearly quantized by sections is dequantized by sections using the side information by the linear dequantization portion 3220. The sections for dequantization correspond to the sections divided for the linear quantization (e.g., if the sections for quantization were divided with respect to the input-axis illustrated in FIG. 11 for encoding, then the sections are divided with respect to the output-axis for decoding). Afterwards, the dequantized data is inversely transformed into the digital signal, preferably PCM data, in operation 3340. This inverse transformation is the inverse of the transformation used for encoding.

Operation 3320 of FIG. 33 is the same as operation 2720, so it is comprised of operations 2800, 2820, and 2840 illustrated in FIG. 28. Referring to FIG. 28, first, the sample data that are linearly quantized by sections is scaled inversely to the scaling used for quantization by the inverse scaling portion 2600 using the bit allocation information, in operation 2800. Afterwards, the inversely scaled data is linearly dequantized in each section in the section linear dequantization portion 2610, in operation 2820. The dequantized data is then denormalized by the denormalization portion 2620 by using an inverse scale factor that corresponds to the scaling factor used for quantization, in operation 2840.

A digital signal is encoded using a plurality of lookup tables. In other words, the numbers of bits allocated for frequency bands are extracted from an optimal lookup table selected from the lookup tables according to characteristics of an input signal. Thus, control of the amount of bits adequate for the characteristics of the input signal is possible. Also, an additional calculation can be saved by using occupancy rates of the frequency bands, which are the same as addresses of each lookup table, as a characteristic of the input signal.

In addition, by encoding a digital signal using linear quantization by sections, the complexity of a non-linear quantizer can be significantly reduced while improving a sound quality compared to a general linear quantizer in consideration of a distribution of audio data.

Furthermore, when frame length information is included in the end of the frame , a point of effective audio data to be reproduced upon generation of an impact can be accurately searched for. Therefore, a period of time when reproduction of audio data is protected from the impact can be extended due to the encoding according to an embodiment of the present invention, and a clean sound without interruptions can be provided to users within the protection-from-impact period of time regardless of an encoding rate.

Embodiments of the present invention can be embodied as computer (including all devices that have information processing functions) readable codes in a computer storage such as a computer readable recording medium. The computer readable recording medium is any data storage device that can store data which can be thereafter read by a computer system. Examples of the computer readable recording medium include read-only memory (ROM), random-access memory (RAM), CD-ROMs, magnetic tapes, floppy disks, and optical data storage devices.

Although a few embodiments of the present invention have been shown and described, it would be appreciated by those skilled in the art that changes may be made in these embodiments without departing from the invention, the scope of which is defined in the claims.

**Claims**

1. A method of encoding a digital audio signal, comprising:

   transforming a digital input signal into samples so that redundant information among signals can be removed;
   obtaining a number of bits to be allocated for each of a plurality of quantization units;
   quantizing the samples using the number of bits allocated for each quantization unit; and
   producing a bitstream having a frame structure including a first area (1410, 1520) which stores encoded data from the quantized samples and predetermined side information,
   wherein quantizing the samples using the number of bits allocated for each quantization unit comprises dividing a distribution of samples within each quantization unit into a predetermined number of sections and linearly quantizing the samples using the allocated number of bits on a section-by-section basis;
   **characterized in that** the step of producing a bitstream from the quantized samples and predetermined side information stores encoded information about a frame length in a second area (1420,1530) at the end of the frame, wherein the size of the second area (1420, 1530) is constant for all frames.

2. An apparatus for encoding a digital audio signal, comprising:

   a data transformation portion (1300) arranged to transform a digital input signal into samples so that redundant information among signals can be removed;
   a number-of-bits-to-be-allocated obtaining portion (1310, 1320, 1330, 1340) including a lookup table (1320) arranged to obtain the number of bits to be allocated for each of a plurality of quantization units;
   a quantization portion (1360) quantizing the samples using the number of bits allocated for each quantization unit by the bit obtaining portion; and

a bitstream producing portion (1370) arranged to produce a bitstream having a frame structure including a first area (1410, 1520) which stores encoded data from the quantized samples and predetermined side information, wherein the quantization portion (1360) comprises a linear quantization portion arranged to divide a distribution of samples within each quantization unit into a predetermined number of sections and to linearly quantize the samples using the allocated number of bits on a section-by-section basis,

**characterised in that** the bitstream producing portion (1370) is arranged to store encoded information about frame length in a second area (1420,1530) at the end of the frame,

so that information about a frame length is included in the end of the frame, wherein the size of the second area (1420, 1530) is constant for all frames.

3. The apparatus of claim 2, wherein the occupancy rate is one of a larger occupancy rate between an occupancy rate of a squared scale factor of a frequency band and an occupancy rate of a mean power of samples within the frequency band and a larger occupancy rate between an occupancy rate of a scale factor of a frequency band and an occupancy rate of a mean value of samples within the frequency band.

4. A method of decoding a digital audio signal, comprising:

extracting data that is quantized and side information from a bitstream;

dequantizing the quantized data using the side information; and

producing a digital signal from the dequantized data using an inverse transformation of a transformation used for encoding, wherein extracting data comprises extracting data that is linearly quantized by sections, and dequantizing comprises dequantizing the linearly quantized data by sections corresponding to the sections divided for the linear quantization,

**characterised in that** extracting data comprises extracting quantized data, side information, and frame length information from a bitstream comprised of frames, having a frame structure including a first area (1410, 1520) which stores encoded data, wherein the frame length information is stored in a second area (1420,1530) at the end of each frame, wherein the size of the second area (1420, 1530) is constant for all frames.

5. The method of claim 4 wherein the side information includes at least a scale factor of each quantization unit and a number of bits to be allocated for each quantization unit.

6. The method of any of claims 4 to 5 wherein the inverse transformation of the dequantized digital signal is performed using one of an inverse modified discrete cosine transform, an inverse fast Fourier transform, an inverse discrete cosine transform, and a sub-band synthesis filtering.

7. An apparatus for decoding a digital audio signal, comprising:

a bitstream analyzing portion arranged to extract quantized data and side information from a bitstream;

a dequantization portion arranged to dequantize the quantized data using the side information; and

an inverse transformation portion arranged to produce a digital signal from the dequantized data using an inverse transformation of a transformation used for encoding, wherein the bitstream analyzing portion comprises a bit unpacking portion arranged to extract linearly quantized data and side information from a bitstream, wherein the dequantization portion comprises a linear dequantization portion arranged to dequantize the linearly quantized data by sections corresponding to the sections divided for the linear quantization, using the side information.

**characterised in that** the bitstream analyzing portion is arranged to extract quantized data, side information, and frame length information from a bitstream comprised of frames having a frame structure including a first area (1410, 1520) which stores encoded data, wherein the frame length information is stored in a second area (1420,1530) at the end of each frame, wherein the size of the second area (1420, 1530) is constant for all frames.

8. The apparatus of claim 7, wherein the side information includes at least a scale factor of each quantization unit and a number of bits to be allocated for each quantization unit.

9. The apparatus of any of claims 7 to 8, wherein the linear dequantization portion comprises:

an inverse scaling portion arranged to perform an inverse scaling of a scaling used for quantization on the data which is linearly quantized by sections, by using bit allocation information included in the side information of the bitstream analyzing portion;
a section linear dequantization portion arranged to linearly dequantize the inversely scaled data by the sections; and
a denormalizing portion arranged to denormalize the dequantized data using an inverse scale factor corresponding to a scale factor used for quantization.

10. A computer program comprising computer program code means adapted to perform all the steps of any of claims 1 or claims 4 when said program is run on a computer.

11. A computer readable medium comprising a computer program as claimed in claim 10.


**Patentansprüche**

1. Verfahren zum Codieren eines digitalen Audiosignals, das Folgendes beinhaltet:

Umwandeln eines digitalen Eingangssignals in Samples, so dass redundante Informationen zwischen Signalen entfernt werden können;
Erlangen einer Anzahl von zuzuordnenden Bits für jede der mehreren Quantisierungseinheiten;
Quantisieren der Samples mit der Anzahl von zugeordneten Bits für jede Quantisierungseinheit; und
Erzeugen eines Bitstroms mit einer Frame-Struktur einschließlich eines ersten Bereichs (1410, 1520), der codierte Daten von den quantisierten Samples und vorbestimmte Nebeninformationen speichert,
wobei das Quantisieren der Samples anhand der Anzahl von zugeordneten Bits für jede Quantisierungseinheit das Unterteilen einer Verteilung von Samples in jeder Quantisierungseinheit in eine vorbestimmte Anzahl von Sektionen und das lineare Quantisieren der Samples anhand der zugeordneten Anzahl von Bits auf einer sektionsweisen Basis beinhaltet;
**dadurch gekennzeichnet, dass** der Schritt des Erzeugens eines Bitstroms von den quantisierten Samples und den vorbestimmten Nebeninformationen codierte Informationen über eine Frame-Länge in einem zweiten Bereich (1420, 1530) am Ende des Frame speichert, wobei die Größe des zweiten Bereichs (1420, 1530) für alle Frames konstant ist.

2. Vorrichtung zum Codieren eines digitalen Audiosignals, die Folgendes umfasst:

einen Datentransformationsteil (1300) zum Transformieren eines digitalen Eingangssignals in Samples, so dass redundante Informationen zwischen Signalen entfernt werden können;
einen Teil (1310, 1320, 1330, 1340) zum Erlangen von zuzuordnenden Bitzahlen einschließlich einer Lookup-Tabelle (1320) zum Erlangen der Anzahl von zuzuordnenden Bits für jede aus einer Mehrzahl von Quantisierungseinheiten;
einen Quantisierungsteil (1360) zum Quantisieren der Samples anhand der Anzahl von zugeordneten Bits für jede Quantisierungseinheit mit dem Biterlangungsteil; und
einen Bitstromerzeugungsteil (1370) zum Erzeugen eines Bitstroms mit einer Frame-Struktur einschließlich eines ersten Bereichs (1410, 1520), der codierte Daten von den quantisierten Samples und vorbestimmte Nebeninformationen speichert,
wobei der Quantisierungsteil (1360) einen linearen Quantisierungsteil zum Unterteilen einer Verteilung von Samples in jeder Quantisierungseinheit in eine vorbestimmte Anzahl von Sektionen und zum linearen Quantisieren der Samples mittels der zugeordneten Bitzahl auf einer sektionsweisen Basis umfasst,
**dadurch gekennzeichnet, dass** der Bitstromerzeugungsteil (1370) dazu dient, codierte Informationen über Frame-Länge in einem zweiten Bereich (1420, 1530) am Ende des Frame zu speichern,
so dass Informationen über eine Frame-Länge im Ende des Frame enthalten sind, wobei die Größe des zweiten Bereichs (1420, 1530) für alle Frames konstant ist.

3. Vorrichtung nach Anspruch 2, wobei die Belegungsrate eine aus einer größeren Belegungsrate zwischen einer Belegungsrate eines quadratischen Skalenfaktors eines Frequenzbands und einer Belegungsrate einer mittleren Leistung von Samples in dem Frequenzband und einer größeren Belegungsrate zwischen einer Belegungsrate eines Skalenfaktors eines Frequenzbands und einer Belegungsrate eines Mittelwerts von Samples in dem Frequenzband ist.

4. Verfahren zum Decodieren eines digitalen Audiosignals, das Folgendes beinhaltet:

Extrahieren von Daten, die quantisiert werden, und von Nebeninformationen aus einem Bitstrom;
Entquantisieren der quantisierten Daten mittels der Nebeninformationen; und
Erzeugen eines digitalen Signals von den entquantisierten Daten mit einer Umkehrtransformation einer zum Codieren verwendeten Transformation, wobei das Extrahieren von Daten das Extrahieren von nach Sektionen linear quantisierten Daten beinhaltet und das Entquantisieren das Entquantisieren der linear quantisierten Daten nach Sektionen beinhaltet, die den für die lineare Quantisierung unterteilten Sektionen entsprechen,
**dadurch gekennzeichnet, dass** das Extrahieren von Daten das Extrahieren von quantisierten Daten, Nebeninformationen und Frame-Längeninformationen aus einem Bitstrom bestehend aus Frames mit einer Frame-Struktur einschließlich eines ersten Bereichs (1410, 1520) beinhaltet, der codierte Daten speichert, wobei die Frame-Längeninformationen in einem zweiten Bereich (1420, 1530) am Ende jedes Frame gespeichert werden, wobei die Größe des zweiten Bereichs (1420, 1530) für alle Frames konstant ist.

5. Verfahren nach Anspruch 4, wobei die Nebeninformationen wenigstens einen Skalenfaktor für jede Quantisierungseinheit und eine Anzahl von zuzuordnenden Bits für jede Quantisierungseinheit beinhalten.

6. Verfahren nach einem der Ansprüche 4 bis 5, wobei die Umkehrtransformation des entquantisierten digitalen Signals mit einer aus inversen modifizierten diskreten Kosinustransformation, einer inversen Fast-FourierTransformation, einer inversen diskreten Kosinustransformation und einer Subband-Synthesefilterung durchgeführt wird.

7. Vorrichtung zum Decodieren eines digitalen Audiosignals, die Folgendes umfasst:

   einen Bitstromanalyseteil zum Extrahieren von quantisierten Daten und Nebeninformationen aus einem Bitstrom;
   einen Entquantisierungsteil zum Entquantisieren der quantisierten Daten anhand der Nebeninformationen; und
   einen Umkehrtransformationsteil zum Erzeugen eines digitalen Signals von den entquantisierten Daten mittels einer Umkehrtransformation einer zum Codieren verwendeten Transformation, wobei der Bitstromanalyseteil einen Bitauspackteil zum Extrahieren von linear quantisierten Daten und Nebeninformationen aus einem Bitstrom umfasst,
   wobei der Entquantisierungsteil einen linearen Entquantisierungsteil zum Entquantisieren der linear quantisierten Daten nach Sektionen entsprechend den für die lineare Quantisierung unterteilten Sektionen anhand der Nebeninformationen umfasst,
   **dadurch gekennzeichnet, dass** der Bitstromanalyseteil zum Extrahieren von quantisierten Daten, Nebeninformationen und Frame-Längeninformationen aus einem Bitstrom bestehend aus Frames mit einer Frame-Struktur einschließlich eines ersten Bereichs (1410, 1520) angeordnet ist, der codierte Daten speichert, wobei die Frame-Längeninformationen in einem zweiten Bereich (1420, 1530) am Ende jedes Frame gespeichert werden, wobei die Größe des zweiten Bereichs (1420, 1530) für alle Frames konstant ist.

8. Vorrichtung nach Anspruch 7, wobei die Nebeninformationen wenigstens einen Skalenfaktor für jede Quantisierungseinheit und eine Anzahl von zuzuordnenden Bits für jede Quantisierungseinheit beinhalten.

9. Vorrichtung nach einem der Ansprüche 7 bis 8, wobei der lineare Entquantisierungsteil Folgendes umfasst:

   einen Umkehrskalierungsteil zum Ausführen einer umgekehrten Skalierung einer zur Quantisierung verwendeten Skalierung an den Daten, die nach Sektionen linear quantisiert wurden, anhand von Bitzuordnungsinformationen, die in den Nebeninformationen des Bitstromanalyseteils enthalten sind;
   einen Sektions-Linearentquantisierungsteil zum linearen Entquantisieren der umgekehrt skalierten Daten nach den Sektionen; und
   einen Entnormalisierungsteil zum Entnormalisieren der entquantisierten Daten mit einem Umkehrskalenfaktor, der einem zum Quantisieren benutzten Skalenfaktor entspricht.

10. Computerprogramm, das Computerprogrammcode zum Ausführen aller Schritte nach einem der Ansprüche 1 bis 4 umfasst, wenn das genannte Programm auf einem Computer abgearbeitet wird.

11. Computerlesbares Medium, das ein Computerprogramm nach Anspruch 10 umfasst.

**Revendications**

1. Procédé de codage d'un signal audio numérique, comprenant :

la transformation d'un signal d'entrée numérique en échantillons de telle sorte que les informations redondantes entre les signaux puissent être éliminées ;
l'obtention d'un nombre de bits à affecter pour chacune d'une pluralité d'unités de quantification ;
la quantification des échantillons en utilisant le nombre de bits affecté pour chaque unité de quantification ; et
la production d'un train binaire ayant une structure de trame comportant une première zone (1410, 1520) qui stocke des données codées des échantillons quantifiés et des informations secondaires prédéterminées,
dans lequel la quantification des échantillons en utilisant le nombre de bits affecté pour chaque unité de quantification comprend la division d'une distribution d'échantillons dans chaque unité de quantification en un nombre prédéterminé de sections et la quantification linéaire des échantillons en utilisant le nombre affecté de bits section par section ;
**caractérisé en ce que** l'étape de production d'un train binaire à partir des échantillons quantifiés et des informations secondaires prédéterminées stocke des informations codées relatives à une longueur de trame dans une seconde zone (1420, 1530) à la fin de la trame, la taille de la seconde zone (1420, 1530) étant constante pour toutes les trames.

2. Appareil de codage d'un signal audio numérique, comprenant :

une partie de transformation de données (1300) agencée pour transformer un signal d'entrée numérique en échantillons de telle sorte que les informations redondantes entre les signaux puissent être éliminées ;
une partie d'obtention d'un nombre de bits à affecter (1310, 1320, 1330, 1340) comportant une table de consultation (1320) agencée pour obtenir le nombre de bits à affecter pour chacune d'une pluralité d'unités de quantification ;
une partie de quantification (1360) qui quantifie les échantillons en utilisant le nombre de bits affecté pour chaque unité de quantification par la partie d'obtention de bits ; et
une partie de production de train binaire (1370) agencée pour produire un train binaire ayant une structure de trame comportant une première zone (1410, 1520) qui stocke des données codées des échantillons quantifiés et des informations secondaires prédéterminées,
dans lequel la partie de quantification (1360) comprend une partie de quantification linéaire agencée pour diviser une distribution d'échantillons dans chaque unité de quantification en un nombre prédéterminé de sections et quantifier linéairement les échantillons en utilisant le nombre affecté de bits section par section ;
**caractérisé en ce que** la partie de production de train binaire (1370) est agencée pour stocker des informations codées relatives à une longueur de trame dans une seconde zone (1420, 1530) à la fin de la trame,
de telle sorte que des informations relatives à une longueur de trame soient incluses à la fin de la trame, la taille de la seconde zone (1420, 1530) étant constante pour toutes les trames.

3. Appareil selon la revendication 2, dans lequel le taux d'occupation est l'un d'un taux d'occupation supérieur entre un taux d'occupation d'un facteur d'échelle au carré d'une bande de fréquences et un taux d'occupation d'une puissance moyenne d'échantillons dans la bande de fréquences et d'un taux d'occupation supérieur entre un taux d'occupation d'un facteur d'échelle d'une bande de fréquences et un taux d'occupation d'une valeur moyenne d'échantillons dans la bande de fréquences.

4. Procédé de décodage d'un signal audio numérique, comprenant :

l'extraction de données qui sont quantifiées et d'informations secondaires depuis un train binaire ;
la déquantification des données quantifiées en utilisant les informations secondaires ; et
la production d'un signal numérique à partir des données déquantifiées en utilisant une transformation inverse d'une transformation utilisée pour le codage, l'extraction de données comprenant l'extraction de données qui sont linéairement quantifiées par sections, et la déquantification comprenant la déquantification des données quantifiées linéairement par sections correspondant aux sections divisées pour la quantification linéaire,
**caractérisé en ce que** l'extraction de données comprend l'extraction de données quantifiées, d'informations secondaires, et d'informations de longueur de trame depuis un train binaire composé de trames, ayant une structure de trame comportant une première zone (1410, 1520) qui stocke les données codées, les informations de longueur de trame étant stockées dans une seconde zone (1420, 1530) à la fin de chaque trame, la taille de la seconde zone (1420, 1530) étant constante pour toutes les trames.

**5.** Procédé selon la revendication 4, dans lequel les informations secondaires comportent au moins un facteur d'échelle de chaque unité de quantification et un nombre de bits à affecter pour chaque unité de quantification.

**6.** Procédé selon l'une quelconque des revendications 4 à 5, dans lequel la transformation inverse du signal numérique déquantifié est exécutée en utilisant l'un d'une transformée en cosinus discret modifiée inverse, d'une transformée de Fourier rapide inverse, d'une transformée en cosinus discret inverse et d'un filtrage de synthèse en sous-bande.

**7.** Appareil de décodage d'un signal audio numérique, comprenant :

une partie d'analyse de train binaire agencée pour extraire des données quantifiées et des informations secondaires depuis un train binaire ;
une partie de déquantification agencée pour déquantifier les données quantifiées en utilisant les informations secondaires ; et
une partie de transformation inverse agencée pour produire un signal numérique à partir des données déquantifiées en utilisant une transformation inverse d'une transformation utilisée pour le codage, la partie d'analyse de train binaire comprenant une partie de dépaquetage de bits agencée pour extraire des données quantifiées linéairement et des informations secondaires d'un train binaire,
dans lequel la partie de déquantification comprend une partie de déquantification linéaire agencée pour déquantifier les données quantifiées linéairement par sections correspondant aux sections divisées pour la quantification linéaire, en utilisant les informations secondaires,
**caractérisé en ce que** la partie d'analyse de train binaire est agencée pour extraire des données quantifiées, des informations secondaires, et des informations de longueur de trame depuis un train binaire composé de trames ayant une structure de trame comportant une première zone (1410, 1520) qui stocke les données codées, les informations de longueur de trame étant stockées dans une seconde zone (1420, 1530) à la fin de chaque trame, la taille de la seconde zone (1420, 1530) étant constante pour toutes les trames.

**8.** Appareil selon la revendication 7, dans lequel les informations secondaires comportent au moins un facteur d'échelle de chaque unité de quantification et un nombre de bits à affecter pour chaque unité de quantification.

**9.** Appareil selon l'une quelconque des revendications 7 à 8, dans lequel la partie de déquantification linéaire comprend :

une partie de mise à l'échelle inverse agencée pour effectuer une mise à l'échelle inverse d'une mise à l'échelle utilisée pour la quantification sur les données qui sont quantifiées linéairement par sections, en utilisant des informations d'affectation de bits incluses dans les informations secondaires de la partie d'analyse de train binaire ;
une partie de déquantification linéaire de sections agencée pour déquantifier linéairement les données inversement mises à l'échelle par les sections ; et
une partie de dénormalisation agencée pour dénormaliser les données déquantifiées en utilisant un facteur d'échelle inverse correspondant à un facteur d'échelle utilisé pour la quantification.

**10.** Programme informatique comprenant un moyen de code de programme informatique adapté pour exécuter toutes les étapes selon l'une quelconque des revendications 1 ou 4 quand ledit programme est exécuté sur un ordinateur.

**11.** Support lisible par ordinateur comprenant un programme informatique selon la revendication 10.

FIG. 1 (PRIOR ART)

```
      100                120                130                 140
 FREQUENCY          BIT            QUANTIZATION        BITSTREAM
 MAPPING   →   ALLOCATION    →       PORTION      →   PRODUCING   →
 PORTION          PORTION                                PORTION

                   110
            PSYCHO-
            ACOUSTIC
            MODEL
```

FIG. 2 (PRIOR ART)

```
      200                220                230                 240
 FREQUENCY     NUMBER-OF-       QUANTIZATION        BITSTREAM
 MAPPING   → ALLOCATED-BITS →     PORTION      →   PRODUCING   →
 PORTION       EXTRACTION                             PORTION
                 PORTION

             LOOKUP
             TABLE      — 210
```

## FIG. 3

DIGITAL SIGNAL → | DATA TRANSFORMATION PORTION | 300 → | LINEAR QUANTIZATION PORTION | 360 → | BIT PACKING PORTION | 370 → BITSTREAM

BIT ALLOCATION PORTION — 350

LOOKUP TABLE SELECTION PORTION — 310

FIRST LOOKUP TABLE 320    SECOND LOOKUP TABLE 330    · · ·    n-TH LOOKUP TABLE 340

EP 1 998 321 B1

# FIG. 4

360

```
  400              420            440           460
   |                |              |             |
┌───────────┐  ┌───────────┐  ┌─────────┐  ┌──────────┐
│   DATA    │  │  SECTION  │  │ SCALING │  │ ROUNDING │
│NORMALIZATION│→│QUANTIZATION│→│ PORTION │→│ PORTION  │→
│  PORTION  │  │  PORTION  │  │         │  │          │
└───────────┘  └───────────┘  └─────────┘  └──────────┘
```

# FIG. 5

```
              ┌──────────┐
              │  START   │
              └────┬─────┘
                   ↓
    ┌────────────────────────────┐
    │   TRANSFORMS INPUT DIGITAL  │── 500
    │    SIGNAL INTO SAMPLE DATA  │
    └─────────────┬──────────────┘
                  ↓
    ┌────────────────────────────┐
    │      SELECT LOOKUP TABLE    │
    │ ACCORDING TO CHARACTERISTICS│── 520
    │    OF INPUT DIGITAL SIGNAL  │
    └─────────────┬──────────────┘
                  ↓
    ┌────────────────────────────┐
    │  ALLOCATE NUMBERS OF BITS FOR│── 540
    │    EACH QUANTIZATION UNIT   │
    └─────────────┬──────────────┘
                  ↓
    ┌────────────────────────────┐
    │   LINEARLY QUANTIZE SAMPLE  │── 560
    │      DATA BY SECTIONS       │
    └─────────────┬──────────────┘
                  ↓
    ┌────────────────────────────┐
    │     PERFORM BITPACKING      │── 580
    └─────────────┬──────────────┘
                  ↓
              ┌──────────┐
              │   END    │
              └──────────┘
```

# FIG. 6

520

START

CALCULATE SCALE FACTOR OF EACH FREQUENCY BAND AND MEAN POWER OF INPUT SIGNALS IN EACH FREQUENCY BAND — 600

CALCULATE OCCUPANCY RATE OF SQUARED SCALE FACTOR OF EACH FREQUENCY BAND AND OCCUPANCY RATE OF MEAN POWER OF INPUT SIGNALS IN EACH FREQUENCY BAND — 610

SELECT A LARGER VALUE BETWEEN THE TWO CALCULATED OCCUPANCY RATES AS OCCUPANCY RATE OF EACH FREQUENCY BAND — 620

CALCULATE NUMBER OF FREQUENCY BANDS (LP) WHOSE OCCUPANCY RATES ARE LOWER THAN OR EQUAL TO REFERENCE OCCUPANCY (HP) WHOSE OCCUPANCY RATES ARE EQUAL TO OR HIGHER THAN REFERENCE OCCUPANCY RATE — 630

SELECT ONE OF PLURALITY OF LOOKUP TABLES ACCORDING TO LP OR HP — 640

END

## FIG. 7A

## FIG. 7B

# FIG. 8

POERATION 540

CALCULATE NUMBER OF BITS ACTUALLY ALLOCATED TO THE ENTIRE INPUT SIGNAL — 810

IS NUMBER OF BITS ACTUALLY ALLOCATED TO THE ENTIRE INPUT SIGNAL EQUAL TO NUMBER OF BITS REQUIRED TO BE ALLOCATED FOR THE ENTIRE INPUT SIGNAL ? — 820

YES

NO

IS NUMBER OF ACTUALLY ALLOCATED BITS GREATER THAN NUMBER OF BITS REQUIRED TO BE ALLOCATED ? 830

NO

YES

840

850

DECREASE NUMBER OF BITS ACTUALLY ALLOCATED FOR EACH FREQUENCY BAND BY ONE UNTIL BEING EQUAL TO NUMBER OF BITS REQUIRED TO BE ALLOCATED

INCREASE NUMBER OF ACTUALLY ALLOCATED BITS FOR EACH FREQUENCY BAND BY ONE UNTIL BEING EQUAL TO NUMBER OF BITS REQUIRED TO BE ALLOCATED

POERATION 560

# FIG. 9

560

| NORMALIZE SAMPLE DATA | 900 |

| APPLY LINEAR FUNCTIONS SET BY SECTIONS TO SAMPLE DATA | 920 |

| SCALE MAPPED SAMPLE DATA USING THE NUMBER OF ALLOCATED BITS | 940 |

| ROUND THE SCALED SAMPLE DATA | 960 |

# FIG. 10

# FIG. 11

FIG. 12

EP 1 998 321 B1

# FIG. 13

FIG. 14

| (t−1)TH FRAME | | t−TH FRAME | |
|---|---|---|---|
| ENCODED DATA | FRAME LENGTH INFORMATION | ENCODED DATA | FRAME LENGTH INFORMATION |
| 1410 | 1420 | 1410 | 1420 |

FIG. 15

| (t−1)TH FRAME | | | t−TH FRAME | | |
|---|---|---|---|---|---|
| SYNC INFORMATION | ENCODED DATA | FRAME LENGTH INFORMATION | SYNC INFORMATION | ENCODED DATA | FRAME LENGTH INFORMATION |
| 1510 | 1520 | 1530 | 1510 | 1520 | 1530 |

# FIG. 16

```
        ┌──────────────┐
        │    START     │
        └──────┬───────┘
               │
        ┌──────▼────────────────────┐
        │ TRANSFORMS INPUT DIGITAL   │
        │ SIGNAL INTO SAMPLE DATA    │──1600
        └──────┬────────────────────┘
               │
        ┌──────▼────────────────────┐
        │ SELECT LOOKUP TABLE        │
        │ ACCORDING TO CHARACTERISTICS│──1620
        │ OF INPUT DIGITAL SIGNAL    │
        └──────┬────────────────────┘
               │
        ┌──────▼────────────────────┐
        │ ALLOCATE NUMBERS OF BITS FOR│
        │ EACH QUANTIZATION UNIT     │──1640
        └──────┬────────────────────┘
               │
        ┌──────▼────────────────────┐
        │ QUANTIZE SAMPLE DATA       │──1660
        └──────┬────────────────────┘
               │
        ┌──────▼────────────────────┐
        │ PRODUCE BITSTREAM          │
        │ COMPRISED OF FRAMES        │──1680
        └──────┬────────────────────┘
               │
        ┌──────▼───────┐
        │     END      │
        └──────────────┘
```

# FIG. 17

# FIG. 18

# FIG. 19

EP 1 998 321 B1

# FIG. 20

```
        ┌──────────────┐
        │    SRTAT     │
        └──────────────┘
               │
   ┌───────────────────────────┐
   │  TRANSFORMS INPUT DIGITAL  │─── 2000
   │   SIGNAL INTO SAMPLE DATA  │
   └───────────────────────────┘
               │
   ┌───────────────────────────┐
   │     SELECT LOOKUP TABLE    │
   │ ACCORDING TO CHARACTERISTICS│─── 2020
   │    OF INPUT DIGITAL SIGNAL  │
   └───────────────────────────┘
               │
   ┌───────────────────────────┐
   │  ALLOCATE NUMBERS OF BITS FOR│─── 2040
   │    EACH QUANTIZATION UNIT   │
   └───────────────────────────┘
               │
   ┌───────────────────────────┐
   │   LINEARLY QUANTIZE SAMPLE  │─── 2060
   │       DATA BY SECTIONS      │
   └───────────────────────────┘
               │
   ┌───────────────────────────┐
   │      PRODUCE BITSTREAM      │─── 2080
   │    COMPRISED OF FRAMES      │
   └───────────────────────────┘
               │
        ┌──────────────┐
        │     END      │
        └──────────────┘
```

# FIG. 21

START

INCLUDE INPUT SIGNALS HAVING VARIOUS CHARACTERISTICS CLASSIFIED INTO GROUPS OF INPUT SIGNALS HAVING IDENTICAL CHARACTERISTICS — 2100

DIVIDE ONE OF INPUT SIGNALS HAVING IDENTICAL CHARACTERISTIC BY FREQUENCY BANDS — 2110

CALCULATE THE NUMBER OF BITS TO BE ALLOCATED FOR EACH FREQUENCY BAND OF INPUT SIGNAL USING PSYCHOACOUSTIC MODEL — 2120

CALCULATE ADDRESS VALUES FOR FREQUENCY BANDS OF INPUT SIGNAL — 2130

RECORD THE FREQUENCY OF CALCULATIONS OF THE NUMBER OF BITS CALCULATED IN OPERATION 2120 — 2140

HAVE ALL OF INPUT SIGNALS HAVING IDENTICAL CHARACTERISTIC UNDERGONE OPERATIONS 2110 THROUGH 2140 ? — 2150

NO

YES

STORE NUMBER OF BITS THAT IS THE MOST FREQUENTLY CALCULATED AMONG THE NUMBERS OF BITS STORED IN EACH OF THE ADDRESSES FOR THE FREQUENCY BANDS, AS THE NUMBER OF BITS TO BE ALLOCATED FOR EACH FREQUENCY BAND TO PRODUCE LOOKUP TABLE — 2160

HAVE LOOKUP TABLES FOR ALL CHARACTERISTICS OF INPUT SIGNALS BEEN PRODUCED ? 2170

NO

YES

END

# FIG. 22

START

INCLUDE PREDETERMINED NUMBER OF INPUT SIGNALS — 2200

CLASSIFY INPUT SIGNALS ACCORDING
TO CHARACTERISTICS OF INPUT SIGNALS — 2210

DIVIDE ONE OF INPUT SIGNALS HAVING IDENTICAL
CHARACTERISTIC BY FREQUENCY BANDS — 2220

CALCULATE THE NUMBER OF BITS TO BE ALLOCATED
FOR EACH FREQUENCY BAND OF INPUT
SIGNAL USING PSYCHOACOUSTIC MODEL — 2230

CALCULATE ADDRESS VALUES FOR
FREQUENCY BANDS OF INPUT SIGNAL — 2240

RECORD THE FREQUENCY OF CALCULATIONS OF THE
NUMBER OF BITS CALCULATED IN OPERATION 2230 — 2250

HAVE ALL
OF INPUT SIGNALS HAVING
IDENTICAL CHARACTERISTIC UNDERGONE
OPERATIONS 2220 THROUGH
2250 ? — 2260

NO

YES

STORE NUMBER OF BITS THAT IS THE MOST FREQUENTLY
CALCULATED AMONG THE NUMBERS OF BITS STORED
IN EACH OF THE ADDRESSES FOR THE FREQUENCY
BANDS, AS THE NUMBER OF BITS TO BE ALLOCATED
FOR EACH FREQUENCY BAND TO PRODUCE LOOKUP TABLE — 2270

HAVE
LOOKUP TABLES FOR ALL
CHARACTERISTICS OF INPUT SIGNALS
BEEN PRODUCED ?

NO

2280

YES

END

# FIG. 23

| ADDRESS | 0 | 1 | 2 | 3 | 4 | | 127 |
|---------|---|---|---|---|---|---|-----|
| SR | 1.0000000 | 0.8404964 | 0.7071068 | 0.5946036 | 0.5000000 | | 0.0000000 |

# FIG. 24

| NUMBER OF BITS TO BE ALLOCATED / ADDRESS | 0 | 1 | · · · | 7 | 8 | · · · | 14 | 15 |
|---|---|---|---|---|---|---|---|---|
| ⋮ | | | | | | | | |
| 5 | 2 | 3 | · · · | 1300 | 6543 | · · · | 189 | 89 |
| ⋮ | | | | | | | | |
| 30 | 5 | 3 | · · · | 5656 | 787 | · · · | 547 | 54 |
| 31 | | | | | | | | |
| ⋮ | | | | | | | | |
| 61 | 7890 | 2356 | · · · | 56 | 3 | · · · | 0 | 0 |

# FIG. 25

BITSTREAM → | BITSTREAM UNPACKING PORTION | (2500) → | LINEAR DEQUANTIZATION PORTION | (2520) → | INVERSE TRANSFORMATION PORTION | (2540) → DIGITAL SIGNAL

# FIG. 26

(2520)

→ | INVERSE SCALING PORTION | (2600) → | SECTION LINEAR DEQUANTIZATION PORTION | (2610) → | DENORMALIZATION SCALING | (2620) →

EP 1 998 321 B1

# FIG. 27

```
        ┌─────────────┐
        │    START    │
        └─────────────┘
               │
               ▼
┌──────────────────────────────┐
│   EXTRACT LINEAR QUANTIZED    │
│   SAMPLE DATA AND SIDE        │——— 2700
│   INFORMATION FROM AUDIO      │
│   BITSTREAM                   │
└──────────────────────────────┘
               │
               ▼
┌──────────────────────────────┐
│  DEQUANTIZE LINEAR QUANTIZED  │
│  SAMPLE DATA USING SIDE       │——— 2720
│  INFORMATION                  │
└──────────────────────────────┘
               │
               ▼
┌──────────────────────────────┐
│  INVERSELY TRANSFORM          │
│  DEQUANTIZED DATA INTO        │——— 2740
│  DIGITAL SIGNAL               │
└──────────────────────────────┘
               │
               ▼
        ┌─────────────┐
        │     END     │
        └─────────────┘
```

# FIG. 28

2720

```
               │
               ▼
┌──────────────────────────────┐
│  INVERSELY SCALE LINEAR       │
│  QUANTIZED SAMPLE DATA USING  │——— 2800
│  ALLOCATION INFORMATION       │
└──────────────────────────────┘
               │
               ▼
┌──────────────────────────────┐
│ LINEARLY DEQUANTIZE           │
│ INVERSELY-SCALED DATA IN      │——— 2820
│ EACH SECTION                  │
└──────────────────────────────┘
               │
               ▼
┌──────────────────────────────┐
│  DENORMALIZE DEQUANTIZED      │——— 2840
│  DATA                         │
└──────────────────────────────┘
               │
               ▼
```

# FIG. 29

```
         2900                    2920                     2940
          |                       |                        |
   ┌──────────────┐        ┌──────────────┐        ┌──────────────┐
   │  BITSTREAM   │        │              │        │   INVERSE    │
──→│  ANALYZING   │───────→│DEQUANTIZATION│───────→│TRANFORMATION │──→
   │   PORTION    │        │   PORTION    │        │   PORTION    │
   └──────────────┘        └──────────────┘        └──────────────┘
```

# FIG. 30

```
                                  2900
                                   |
   ┌ ─ ─ ─ ─ ─ ─ ─ ─ ─ ─ ─ ─ ─ ─ ─ ─ ─ ─ ─ ─ ─ ─ ─ ─ ─ ─ ─ ─ ─ ┐

     3000            3020            3040            3060
      |               |               |               |
   ┌─────────┐   ┌─────────┐   ┌─────────┐   ┌──────────────┐
   │  SYNC   │   │  SIDE   │   │QUANTIZED│   │ FRAME LENGTH │
   │INFORMA- │   │INFORMA- │   │  DATA   │   │ INFORMATION  │
   │TION     │   │TION     │   │ANALYZING│   │  ANALYZING   │
   │ANALYZING│   │ANALYZING│   │ PORTION │   │   PORTION    │
   │ PORTION │   │ PORTION │   └─────────┘   └──────────────┘
   └─────────┘   └─────────┘

   └ ─ ─ ─ ─ ─ ─ ─ ─ ─ ─ ─ ─ ─ ─ ─ ─ ─ ─ ─ ─ ─ ─ ─ ─ ─ ─ ─ ─ ─ ┘
```

# FIG. 31

```
            ┌─────────┐
            │  START  │
            └─────────┘
                 │
                 ▼
┌───────────────────────────────────┐
│   EXTRACT QUANTIZED SAMPLED DATA,  │
│   SIDE INFORMATION, AND FRAME      │──── 3100
│   LENGTH INFORMATION FROM          │
│   AUDIO BITSTREAM                  │
└───────────────────────────────────┘
                 │
                 ▼
┌───────────────────────────────────┐
│   DEQUANTIZE QUANTIZED SAMPLE DATA │──── 3120
│   USING SIDE INFORMATION           │
└───────────────────────────────────┘
                 │
                 ▼
┌───────────────────────────────────┐
│   INVERSELY TRANSFORM DEQUANTIZED  │──── 3140
│   DATA INTO DIGITAL SIGNAL         │
└───────────────────────────────────┘
                 │
                 ▼
            ┌─────────┐
            │   END   │
            └─────────┘
```

# FIG. 32

```
        3200              3220                3240
         │                 │                   │
┌──────────────┐   ┌──────────────┐   ┌──────────────┐
│  BITSTREAM   │   │   LINEAR     │   │   INVERSE    │
─▶│  ANALYZING │─▶ │DEQUANTIZATION│─▶ │ TRANFORMATION│─▶
│   PORTION    │   │   PORTION    │   │   PORTION    │
└──────────────┘   └──────────────┘   └──────────────┘
```

# FIG. 33

```
          ┌─────────────┐
          │    START    │
          └──────┬──────┘
                 │
                 ▼
  ┌──────────────────────────────┐
  │  EXTRACT QUANTIZED SAMPLED    │
  │  DATA, SIDE INFORMATION, AND  │──── 3300
  │  FRAME LENGTH INFORMATION     │
  │  FROM AUDIO BITSTREAM         │
  └──────────────┬───────────────┘
                 │
                 ▼
  ┌──────────────────────────────┐
  │  DEQUANTIZE LINEAR QUANTIZED  │──── 3320
  │  SAMPLE DATA USING SIDE       │
  │  INFORMATION                  │
  └──────────────┬───────────────┘
                 │
                 ▼
  ┌──────────────────────────────┐
  │  INVERSELY TRANSFORM          │──── 3340
  │  DEQUANTIZED DATA INTO        │
  │  DIGITAL SIGNAL               │
  └──────────────┬───────────────┘
                 │
                 ▼
          ┌─────────────┐
          │     END     │
          └─────────────┘
```

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **SAITO et al.** Subadaptive Piecewise Linear Quantization for Speech Signal Compression. *IEEE transactions on speech and audio processing,* September 1996, vol. 4 (5